# EUROPÄISCHE PATENTSCHRIFT

(11) **EP 3 617 214 B1**
(45) Veröffentlichungstag und Bekanntmachung des Hinweises auf die Patenterteilung: **10.05.2023**
(21) Anmeldenummer: 18191861.6
(22) Anmeldetag: 30.08.2018
(51) Int. Cl.: C07F 5/02, H01L 51/00

(54) **ORGANISCHES HALBLEITENDES MATERIAL UND DESSEN SYNTHESE UND ORGANISCHES HALBLEITENDES BAUELEMENT MIT DEM MATERIAL**
ORGANIC SEMICONDUCTIVE MATERIAL AND ITS SYNTHESIS AND ORGANIC SEMI-CONDUCTING COMPONENT WITH SAID MATERIAL
MATÉRIAU SEMI-CONDUCTEUR ORGANIQUE ET SA SYNTHÈSE ET COMPOSANT SEMI-CONDUCTEUR ORGANIQUE DOTÉE DUDIT MATÉRIAU

(43) Veröffentlichungstag der Anmeldung: 04.03.2020
(73) Patentinhaber: Heliatek GmbH, 01139 Dresden (DE)
(72) Erfinder: Mirloup, Antoine, 89077 Ulm (DE); D'Souza, Daniel, 01139 Dresden (DE); Fitzner, Roland, 89077 Ulm (DE); Gerdes, Olga, 89077 Ulm (DE); Hildebrandt, Dirk, 89077 Ulm (DE); Mattersteig, Gunter, 89077 Ulm (DE); Weiß, Andre, 01139 Dresden (DE)

(56) Entgegenhaltungen:
- XIN-DONG JIANG ET AL: "Synthesis of meso -CF 3 -Substituted BODIPY Compounds with Redshifted Absorption : Synthesis of meso -CF 3 -Substituted BODIPY Compounds with Redshifted Absorption", EUROPEAN JOURNAL OF ORGANIC CHEMISTRY, Bd. 2017, Nr. 34, 15. September 2017 (2017-09-15), Seiten 5074-5079, XP055552332, DE ISSN: 1434-193X, DOI: 10.1002/ejoc.201700800
- LIAO JUNXU ET AL: "Synthesis, optical and electrochemical properties of novelmeso-triphenylamine-BODIPY dyes with aromatic moieties at 3,5-positions", TETRAHEDRON, Bd. 71, Nr. 31, 2015, Seiten 5078-5084, XP029211928, ISSN: 0040-4020, DOI: 10.1016/J.TET.2015.05.054
- ZEYA FENG ET AL: "Regioselective and Stepwise Syntheses of Functionalized BODIPY Dyes through Palladium-Catalyzed Cross-Coupling Reactions and Direct C-H Arylations", JOURNAL OF ORGANIC CHEMISTRY, Bd. 81, Nr. 15, 14. Juli 2016 (2016-07-14) , Seiten 6281-6291, XP055554472, ISSN: 0022-3263, DOI: 10.1021/acs.joc.6b00858
- Sobenina Lubov N. ET AL: "General Route to Symmetric and Asymmetric meso -CF 3 -3(5)-Aryl(hetaryl)- and 3,5-Diaryl(dihetaryl)-BODIPY Dyes", ORGANIC LETTERS, vol. 13, no. 10, 20 May 2011 (2011-05-20), pages 2524-2527, XP055784919, US ISSN: 1523-7060, DOI: 10.1021/ol200360f
- Afonin Andrei V. ET AL: "Structural studies of meso-CF3-3(5)-aryl(hetaryl)- and 3,5-diaryl(dihetaryl)-BODIPY dyes by 1H, 13C and 19F NMR spectroscopy and DFT calculations", JOURNAL OF FLUORINE CHEMISTRY, vol. 145, 1 January 2013 (2013-01-01), pages 51-57, XP055784920, NL ISSN: 0022-1139, DOI: 10.1016/j.jfluchem.2012.11.009

## Beschreibung

### Gebiet der Erfindung

Die Erfindung betrifft ein organisches Material mit einem Dipyrringerüst und dessen Synthese und Verwendung in halbleitenden Bauelementen, speziell in organischen hableitenden Bauelementen.

### Stand der Technik

In der organischen Elektronik werden Verschaltungen aus elektrisch leitfähigen Polymeren oder kleinen organischen Molekülen verwendet.

Die Erfinder verstehen unter sogenannten "kleinen Molekülen" nicht-polymere organische Moleküle mit einer definierten Molekülstruktur und einer molaren Masse zwischen 100 bis 2000 g/mol.

Organisch elektronische Bauelemente können dabei zum Beispiel Displays, Datenspeicher oder Transistoren, insbesondere auch Feldeffekt-Transistoren sein. Diese Bauelemente umfassen auch organisch optoelektronische Bauelemente, beispielsweise organische photoaktive Bauelemente, wie Solarzellen und Photodetektoren, die eine photoaktive Schicht umfassen, in der bei Einfall von Strahlung Ladungsträger, z. B. gebundene Elektronen-Loch-Paare (Exzitonen) erzeugt werden. Weitere optoelektronische Bauelemente sind Licht emittierende elektrolumineszierende Bauelemente, die Licht aussenden, wenn sie von Strom durchflossen werden.

Optoelektronische Bauelemente umfassen mindestens zwei Elektroden, wobei eine Elektrode auf einem Substrat aufgebracht ist und die andere als Gegenelektrode fungiert. Zwischen den Elektroden befindet sich mindestens eine photoaktive Schicht, vorzugsweise mindestens eine organische photoaktive Schicht, als lichtabsorbierende Schicht, die als Misch- oder ein Stapel von Misch- und/oder Einzelschichten ausgebildet sein können. Die Erfinder verstehen unter photoaktiver Schicht, eine Schicht, der aktiv als Absorberschicht durch Absorption von Licht einen Beitrag zur Umwandlung von Lichtenergie in elektrische beiträgt. Weitere Schichten, beispielsweise Transportschichten, können zwischen den Elektroden angeordnet sein. Weiterhin können auch mehrere Schichtfolgen übereinander zwischen den beiden Elektroden zu Tandem- oder Multi-Übergängen gestapelt sein, wobei Schichtfolge mindestens eine photoaktive Schicht und mindestens eine weitere dotierte, undotierte oder teilweise dotierte Schicht als Transportschicht umfasst, vgl. beispielweise pin-/nip-Strukturen gemäß WO 2004 083 958 A2 oder WO 2011 161 108 A1, und wobei jede dieser Schichten aus mehreren Schichten bestehen kann.

Bura u.a., J. Am. Chem. Soc. 2012, 134, 17404-17407.beschreiben beispielsweise Bodipy-Farbstoffe mit Iodarylresten in Mesoposition des Dipyrrin-Grundgerüstes und deren Verwendung in lösemittelprozessierten organischen Solarzellen.

In WO 2015 036 529 A1 wird die Verwendung einer Pyrrolopyrrolbasierten Verbindung in einer Vorrichtung der organischen Elektronik vorgestellt.

WO 2010 133 208 A1 beschreibt einen organischen Halbleiter, der mehrere Schichten umfasst, wobei zumindest eine der Schichten ein Material mit Azabodipy-Grundgerüst umfasst.

Jiang et al. (Eur. J. Org. Chem., 10.1002/ejoc.201700800) offenbart Verbindungen zur Verwendung als NIR-fluoreszierendem Farbstoff.

Liao et al. (Tetrahedron 71 (2015) 5078-5084) offenbart eine Synthese, und optische und elektrochemische Eigenschaften von mesotriphenylamin-BODIPY Farbstoffen mit aromatischen Resten in 3,5-Position.

Feng et al. (J. Org. Chem., Bd. 81, Nr. 15, 2016, Seiten 6281-6291) offenbart eine Synthese von funktionalisierten BODIPY Farbstoffen. Lubov et al. (Organic Letters, 2011, Vol.13, No. 10, 2524-2527) offenbart eine Synthese für BODIPY-Verbindungen und deren Verwendung als rotverschobene Farbstoffe.

Afonin et al. (Journal of Fluorine Chemistry, 145 (2013), 51-57) offenbart eine Synthese für BODIPY-Verbindungen und deren Verwendung als rotverschobene Farbstoffe.

### Zusammenfassung der Erfindung

Durch den Einsatz geeigneter neuartiger organischer Materialien können verschiedene neuartige Bauelemente, bereitgestellt werden. Dadurch ist die Entwicklung neuer Anwendungen, die dünn, flexibel, leicht sowie mit farblicher Variabilität und auch kostengünstig sind, gegeben.

Es sind derzeit, insbesondere für den Bereich nicht-polymerer Verbindungen, nur wenige NIR (Nah-infrarot)-Absorber im Bereich von 650 bis 1400 nm für den Einsatz in organischer Optoelektronik bekannt. NIR-Absorber sind von besonderem Interesse, da sie im nicht-sichtbaren Bereich des Lichtes absorbieren und daher dem menschlichen Betrachter transparent erscheinen oder in Kombination mit farbigen Absorbern ein breiterer Bereich des Sonnenspektrums genutzt werden kann.

Die aus dem Stand der Technik bekannten NIR-Farbstoffe sind teilweise nicht zufriedenstellend. So ist zum Beispiel die Prozessierbarkeit nicht ausreichend und/oder die thermische Stabilität für eine Verdampfung im Vakuum nicht gegeben. Typische organische Infrarotabsorber sind Cyaninfarbstoffe, die beispielsweise in DE 199 57 001 A1 für optische Aufzeichnungsmedien beschrieben werden. Aufgrund des ionischen Aufbaus von Cyaninfarbstoffen sind außerordentlich hohe Verdampfungstemperaturen zu erwarten, die in der Regel praktisch nicht erreicht werden können, da zuvor eine thermische Zersetzung des Farbstoffes eintritt.

Darüber hinaus besitzen viele aus dem Stand der Technik bekannten NIR-Farbstoffe keine befriedigende Absorptionsstärke in dünnen Schichten, beispielsweise auf Grund ungeeigneter Vorzugsorientierung beim Schichtwachstum oder zu geringem molarem Extinktionskoeffizienten, es ist keine ausreichende Photostabilität gegeben, sie verfügen nicht über ausreichende Transporteigenschaften für einen Nutzen der absorbierten Strahlung oder sie passen energetisch nicht in das Bauelement. Darüber hinaus steht einer wirtschaftlichen technischen Anwendung häufig eine zu lange und aufwendige Synthese im Wege.

### Technische Aufgabe

Es werden organische halbleitende Materialien gesucht, die im nahinfraroten (NIR) Bereich zwischen ca. 650 und ca. 1400 nm absorbieren, und die bei Anwendung in organischen elektronischen Bauelementen zu einer Verbesserung der Eigenschaften der Bauelemente führen. Die NIR Absorber sollen synthetisch gut zugänglich, d.h. keine aufwendigen und nur eine begrenzte Zahl von Syntheseschritte beinhalten und sie sollen sich zur Herstellung von vakuum-prozessierten organischen Bauelementen, insbesondere von vakuum-prozessierten organischen Solarzellen oder Photodetektoren eignen.

Idealerweise besitzen die gesuchten Absorbermaterialien eine geeignete Vorzugsorientierung beim Schichtwachstum, so dass diese über günstige Transporteigenschaften von Ladungsträgern für die Nutzung der absorbierten Strahlung genutzt werden können.

Offenbart werden Verbindungen der allgemeinen Formel 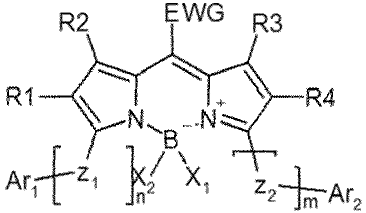 mit den Parametern
- n, m jeweils unabhängig voneinander 0 oder 1 oder 2;
- mit z1 und z2 ausgewählt aus den Formeln (II) bis (IV); 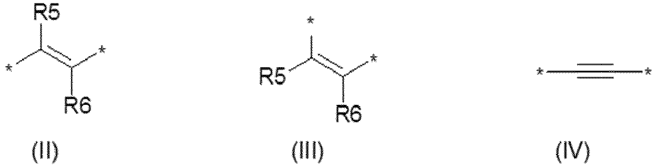 (Die Bezeichnung "*" bezeichnet jeweils eine potentielle Anknüpfstelle des Substituenten z1, z2 an das Dipyrringerüst einerseits und an die Arylsubstituenten Ar1, Ar2 andererseits.)
- mit Ar1, Ar2 jeweils unabhängig voneinander ausgewählt aus Aryl oder Heteroaryl, wobei Ar1 im Falle von n = 0 und/oder Ar2 im Falle von m = 0 der Formel (V) entsprechen, und "*" die Anknüpfstelle des Substituenten Ar1, Ar2 an das Dipyrringerüst bezeichnet, 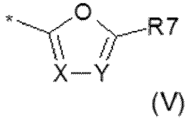
- wobei es sich bei EWG um CN oder eine vollständig oder teilweise fluorierte, verzweigte oder unverzweigte, lineare oder cyclische Alkylkette handelt, wobei Wasserstoffatome der Alkylkette substituiert sein können, und/oder C-Atome der Alkylkette durch Heteroatome ersetzt sein können, bevorzugt ist EWG CN oder CF3.
- mit X1, X2 ausgewählt aus Halogen, CN, Alkyl, fluoriertes oder teilfluoriertes Alkyl, Alkenyl, Alkinyl, Alkoxy, Aryl oder Heteroaryl
- mit R1 bis R4 unabhängig ausgewählt aus H, CN, Halogen, substituiertem oder unsubstituiertem, verzweigtem oder unverzweigtem, linearem oder cyclischem Alkylrest,
- mit R5, R6 unabhängig ausgewählt aus H, CN, Halogen, substituiertem oder unsubstituiertem, verzweigtem oder unverzweigtem, linearem oder cyclischem Alkylrest.

Die C-Atome der Alkylkette des EWGs können durch Heteroatome, wie z. B. Si, O, S oder N-R8 ersetzt sein, wobei R8 ausgewählt ist aus einer Gruppe aus H, Halogen, verzweigtes oder lineares, zyklisches oder offenkettiges Alkyl, bevorzugt mit maximal 20, besonders bevorzugt mit maximal 10 Kohlenstoffeinheiten, sehr besonders bevorzugt mit maximal 6 Kohlenstoffeinheiten, wobei Wasserstoffatome des Alkyls ganz oder teilweise ersetzt sein können, beispielsweise insbesondere durch ein Halogen, bevorzugt F, und/oder C-Atome des Alkyls durch ein Heteroatom, wie z. B. O oder S ersetzt sein können, oder
aus einer Gruppe aus Alkenyl, O-Alkyl, S-Alkyl, O-Alkenyl, S-Alkenyl, Alkinyl, Aryl oder Heteroaryl, jeweils bevorzugt mit maximal 20, besonders bevorzugt mit maximal 10, sehr besonders bevorzugt mit maximal 6 Kohlenstoffeinheiten, wobei bei allen diesen Gruppen Wasserstoffatome ganz oder teilweise ersetzt sein können, beispielsweise insbesondere durch ein Halogen, bevorzugt F, ist, und/oder C-Atome des Alkenyls, Aryls durch ein Heteroatom, wie z. B. O oder S ersetzt sein können, oder
CN, NR'R", mit R' und R" jeweils unabhängig voneinander ausgewählt aus: H, verzweigtes oder lineares, zyklisches oder offenkettiges Alkyl, mit bevorzugt mit maximal 20, besonders bevorzugt mit maximal 10 Kohlenstoffeinheiten, wobei Wasserstoffatome des Alkyls substituiert sein können, z. B. durch Halogen und/oder C-Atome des Alkyls durch Heteroatome, z.B. O oder S, ersetzt sein können, Aryl, Heteroaryl.

### Offenbarung der Erfindung und technischer Wirkung der Erfindung

Erfindungsgemäß wird die technische Aufgabe durch die Verbindungen der allgemeinen Formel I gelöst: 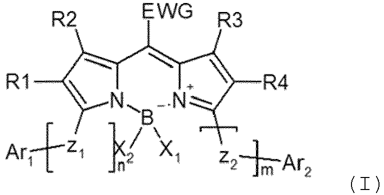
a) mit n, m jeweils unabhängig voneinander 0, 1 oder 2;
b) mit X1, X2 jeweils unabhängig voneinander ausgewählt aus Halogen, CN, Alkyl, fluoriertem oder teilfluoriertem Alkyl, Alkenyl, Alkinyl, Alkoxy, Aryl oder Heteroaryl;
c) mit EWG CF₃;
d) mit z1 und z2 ausgewählt aus den Gruppen (II) bis (IV): 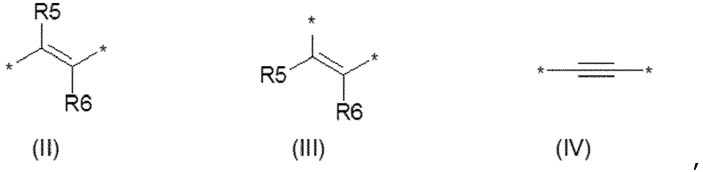 wobei "*" jeweils eine potentielle Anknüpfstelle des Substituenten z1, z2 an das Dipyrringerüst und an die Arylsubstituenten Ar1, Ar2 bezeichnet,
e) mit R1 bis R4 jeweils unabhängig voneinander ausgewählt aus H oder einem Alkyl;
f) mit R5 und R6 jeweils unabhängig ausgewählt aus H, Halogen, CN, einer substituierten oder unsubstituierten, verzweigten oder unverzweigten, linearen oder cyclischen Alkylkette;
g) wobei Ar1 im Falle von n = 0 und/oder Ar2 im Falle von m = 0 der Formel (V) entsprechen, und "*" die Anknüpfstelle des Substituenten Ar1, Ar2 an das Dipyrringerüst bezeichnet, 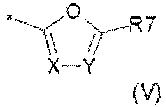
   wobei X ausgewählt ist aus N oder C-R8, wobei Y ausgewählt ist aus N oder C-R9 ist, wobei R7 bis R9 unabhängig voneinander ausgewählt sind aus einer Gruppe bestehend aus H, Halogen, verzweigtem oder linearem, zyklischem oder offenkettigem Alkyl oder Aryl, wobei H-Atome und/oder C-Atome des Alkyls oder Aryls substituiert sein können, oder aus einer Gruppe bestehend aus Alkenyl, O-Alkyl, S-Alkyl, O-Alkenyl, S-Alkenyl, Alkinyl, Aryl oder Heteroaryl, wobei bei allen diesen Gruppen H-Atome substituiert sein können, oder aus CN oder NR'R", mit R' und R" jeweils unabhängig voneinander ausgewählt aus: H, verzweigtem oder linearem, zyklischem oder offenkettigem Alkyl, wobei H- und/oder C-Atome des Alkyls substituiert sein können, oder wobei R7 und R9 zusammen einen homo- oder heterocyclischen, gesättigten oder ungesättigten, substituierten oder unsubstituierten Ring ausbilden können, und
   wobei Ar1 im Fall n > 0 und/oder Ar2 im Fall m > 0 ein substituierter oder unsubstituierter heterocyclischer 5-Ring ist, bevorzugt mit Heteroatomen ausgewählt aus S oder O.

Weitere vorteilhafte Ausgestaltungen der Verbindungen, sowie vorteilhafte Verwendungen der erfindungsgemäßen Verbindungen und organische elektronische Bauelemente enthaltend diese Verbindungen und die Synthese der erfindungsgemäßen Verbindungen sind Gegenstand weiterer Patentansprüche.

### Vorteilhafte Wirkung der Erfindung

Überraschenderweise wurde festgestellt, dass erfindungsgemäße Verbindungen, die als gemeinsames Strukturelement einerseits eine durch Fluoratome induktiv oder durch eine Cyanogruppe sowohl induktiv als auch mesomer elektronenziehende Gruppe EWG in der Meso-Position des Dipyrringrundgerüsts tragen, andererseits in 3,5-Position des Dipyrringrundgerüsts ein konjugiertes System gebunden ist, das durch eine geringe räumliche Ausdehnung gekennzeichnet ist, wie beispielsweise aber nicht beschränkt auf Vinyl-, Alkinyl-oder Furaneinheiten, breit und stark Licht im nahinfraroten Bereich absorbieren. Die Absorption von Licht im sichtbaren Bereich unter 650 nm fällt dagegen verhältnismäßig geringer aus, weshalb die erfindungsgemäßen Verbindungen zur Herstellung von semitransparenten oder transparenten organischen Solarzellen oder Photodetektoren geeignet sind.

Weiterhin weisen diese Verbindungen auch eine erhöhte Ladungsträgerbeweglichkeit auf, so dass neben Photodetektoren oder Solarzellen auch andere organische elektronische Bauelemente, wie z.B. Transistoren oder OLEDs, die die erfindungsgemäßen Verbindungen umfassen, verbesserte elektrische Werte aufweisen können.

Die Erfinder haben weiterhin festgestellt, dass die erfindungsgemäßen Verbindungen auch als ladungsträgertransportierende Schichten verwendet werden können, z.B. als p-leitende Materialien, d.h. es ist damit eine Verwendung sowohl in lichtabsorbierenden Schichten, Absorberschichten, als auch in Ladungsträgertransportschichten innerhalb eines Bauelements möglich.

Die erfindungsgemäßen Verbindungen sind insbesondere sogenannte "kleine Moleküle", wobei darunter nicht-polymere organische Moleküle mit definierten Molekülstruktur und einer molaren Masse zwischen 100 bis 2000 g/mol verstanden werden, die insbesondere auch monodispers sein können.

Die organischen Materialien werden dabei in Form dünner Filme oder kleiner Volumen auf die Substrate aufgedruckt, aufgeklebt, gecoated, aufgedampft oder anderweitig aufgebracht. Für die Herstellung der dünnen Schichten kommen ebenso alle Verfahren in Betracht, die auch für Elektronik auf keramischen oder halbleitenden Trägern verwendet werden.

### Detaillierte Beschreibung der Erfindung

Gegenstand der Erfindung sind chemische Verbindungen der allgemeinen Formel I: 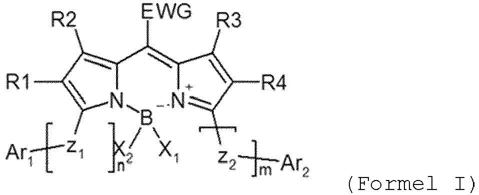
a) mit n, m jeweils unabhängig voneinander 0, 1 oder 2;
b) mit X1, X2 jeweils unabhängig voneinander ausgewählt aus Halogen, CN, Alkyl, fluoriertem oder teilfluoriertem Alkyl, Alkenyl, Alkinyl, Alkoxy, Aryl oder Heteroaryl;
c) mit EWG CF₃;
d) mit z1 und z2 ausgewählt aus den Gruppen (II) bis (IV): 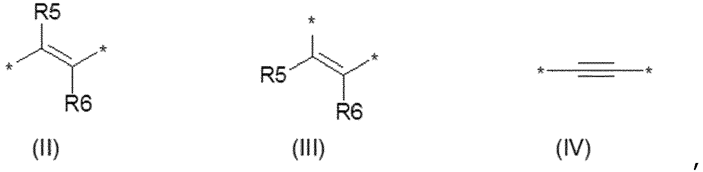 wobei "*" jeweils eine potentielle Anknüpfstelle des Substituenten z1, z2 an das Dipyrringerüst und an die Arylsubstituenten Ar1, Ar2 bezeichnet,
e) mit R1 bis R4 jeweils unabhängig voneinander ausgewählt aus H oder einem Alkyl;
f) mit R5 und R6 jeweils unabhängig ausgewählt aus H, Halogen, CN, einer substituierten oder unsubstituierten, verzweigten oder unverzweigten, linearen oder cyclischen Alkylkette;
g) wobei Ar1 im Falle von n = 0 und/oder Ar2 im Falle von m = 0 der Formel (V) entsprechen, und "*" die Anknüpfstelle des Substituenten Ar1, Ar2 an das Dipyrringerüst bezeichnet, 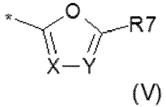
   wobei X ausgewählt ist aus N oder C-R8, wobei Y ausgewählt ist aus N oder C-R9 ist, wobei R7 bis R9 unabhängig voneinander ausgewählt sind aus einer Gruppe bestehend aus H, Halogen, verzweigtem oder linearem, zyklischem oder offenkettigem Alkyl oder Aryl, wobei H-Atome und/oder C-Atome des Alkyls oder Aryls substituiert sein können, oder aus einer Gruppe bestehend aus Alkenyl, O-Alkyl, S-Alkyl, O-Alkenyl, S-Alkenyl, Alkinyl, Aryl oder Heteroaryl, wobei bei allen diesen Gruppen H-Atome substituiert sein können, oder aus CN oder NR'R", mit R' und R" jeweils unabhängig voneinander ausgewählt aus: H, verzweigtem oder linearem, zyklischem oder offenkettigem Alkyl,
   wobei H- und/oder C-Atome des Alkyls substituiert sein können, oder wobei R7 und R9 zusammen einen homo- oder heterocyclischen, gesättigten oder ungesättigten, substituierten oder unsubstituierten Ring ausbilden können, und
   wobei Ar1 im Fall n > 0 und/oder Ar2 im Fall m > 0 ein substituierter oder unsubstituierter heterocyclischer 5-Ring ist, bevorzugt mit Heteroatomen ausgewählt aus S oder O.

In einer bevorzugten Ausführungsform weisen die erfindungsgemäßen Verbindungen keine Ringstruktur zwischen R1 und R2 und/oder zwischen R3 und R4.

In einer Ausführungsform sind X1 und X2 jeweils ein Halogen, bevorzugt F.

In einer Ausführungsform sind R1 bis R4 unabhängig voneinander ausgewählt aus H, Methyl oder Alkyl, bevorzugt sind R1 bis R4 H.

In einer Ausführungsform sind R5 oder R6 unabhängig voneinander ausgewählt aus H, Methyl oder Alkyl, bevorzugt sind R5 oder R6 H.

In Formel (V) ist X ausgewählt aus N oder C-R8, und Y ausgewählt aus N oder C-R9. R7 bis R9 sind unabhängig voneinander ausgewählt
- aus einer Gruppe aus H, Halogen, verzweigtes oder lineares, zyklisches oder offenkettiges Alkyl, bevorzugt mit maximal 20, besonders bevorzugt mit maximal 10 Kohlenstoffeinheiten, sehr besonders bevorzugt mit maximal 6 Kohlenstoffeinheiten, wobei Wasserstoffatome des Alkyls ganz oder teilweise ersetzt sein können, beispielsweise insbesondere durch ein Halogen, bevorzugt F, und/oder C-Atome des Alkyls durch ein Heteroatom, wie z. B. O oder S ersetzt sein können, oder
- aus einer Gruppe aus Alkenyl, O-Alkyl, S-Alkyl, O-Alkenyl, S-Alkenyl, Alkinyl, Aryl oder Heteroaryl, jeweils bevorzugt mit maximal 20, besonders bevorzugt mit maximal 10, sehr besonders bevorzugt mit maximal 6 Kohlenstoffeinheiten, wobei bei allen diesen Gruppen Wasserstoffatome ganz oder teilweise ersetzt sein können, beispielsweise insbesondere durch ein Halogen, bevorzugt F, ist, und/oder C-Atome durch ein Heteroatom, wie z. B. O oder S ersetzt sein können, oder
- CN, NR'R", mit R' und R" jeweils unabhängig voneinander ausgewählt aus: H, verzweigtes oder lineares, zyklisches oder offenkettiges Alkyl, mit bevorzugt mit maximal 20, besonders bevorzugt mit maximal 10 Kohlenstoffeinheiten, wobei Wasserstoffatome des Alkyls substituiert sein können, z. B. durch Halogen und/oder C-Atome des Alkyls durch Heteroatome, z.B. O oder S, ersetzt sein können, Aryl, Heteroaryl.

Die Erfinder verstehen unter einem O-Alkyl, O-Alkenyl bzw. unter einem S-Alkyl oder S-Alkenyl eine Alkyl/Alkenyl bei dem mindestens ein C-Atom durch O bzw. S ersetzt ist.

In einer Ausführungsform ist die erfindungsgemäße Verbindung spiegelsymmetrisch gegenüber der Achse gebildet durch EWG und B. Die zuvor beschriebenen Ausführungsformen können miteinander kombiniert werden.

Gemäß der vorliegenden Erfindung kann es sich um folgende erfindungsgemäße Verbindungen/Strukturen handeln:

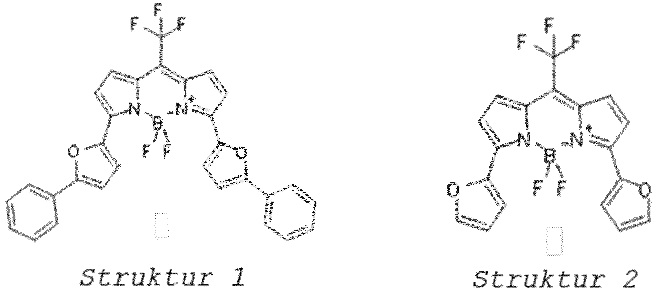

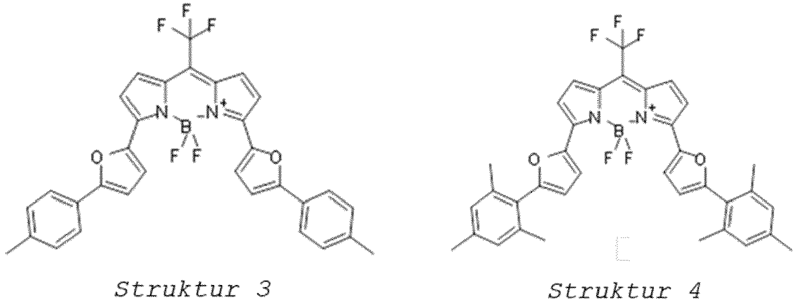

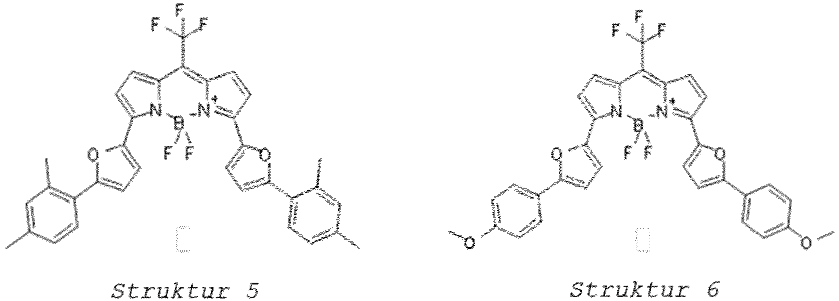

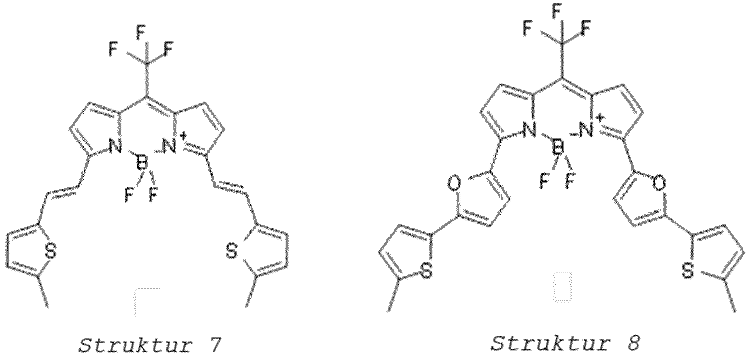

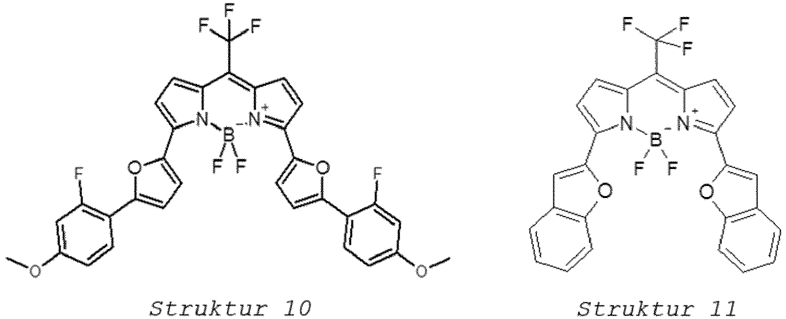

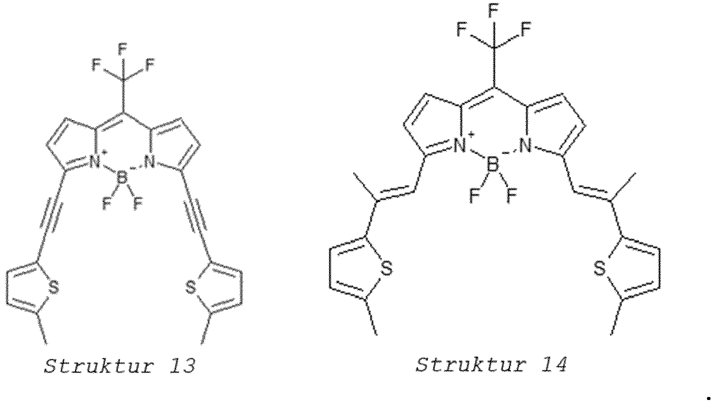

Gemäß eines weiteren Aspekts der vorliegenden Erfindung können die oben beschriebenen erfindungsgemäßen Verbindungen in organischen elektronischen Bauelementen verwendet werden. Die Verwendung erfolgt vorzugsweise als Absorbermaterial (Licht absorbierendes Material) in den photoaktiven Schichten (Absorberschichten), insbesondere in organischen Solarzellen oder Photodetektoren. Weiterhin können die Materialien in Ladungsträgerschichten verwendet werden. Dabei ist der Einsatz nicht auf Licht absorbierende Geräte/Bauelemente beschränkt und es ist ein Einsatz beispielsweise in OLEDs denkbar.

Die Verwendung in einem Halbleiterbauelement kann sowohl in einer Einzelschicht, als auch in einer Mischschicht erfolgen. Eine Mischschicht kann beispielsweise durch Co-Verdampfen zweier oder mehrerer Materialien erfolgen. Damit kann eine Absorberschicht als Mischschicht hergestellt werden, wobei mindestens ein Material als Donor und mindestens ein Material als Akzeptor fungiert. An der Grenzschicht zwischen Donor und Akzeptor werden Excitonen getrennt. Der Vorteil der Verwendung einer Mischschicht (bulc-heterojunction) gegenüber einem planaren Heteroübergang, bei dem Donor und Akzeptor als zwei aneinandergrenzende Schichten vorliegen, ist, dass die Excitonen nur einen geringen Weg bis zur nächsten Grenzschicht zurücklegen müssen. Als Akzeptormaterialien können beispielsweise die Materialien gemäß WO 2004 083 958 A2 verwendet werden.

### Synthese

Die Synthese der erfindungsgemäßen Verbindungen kann nach einem Baukastensystem erfolgen. Dabei werden Bausteine auf parallelen Synthesewegen bereitgestellt, die vorteilhafterweise in einem späten Reaktionsschritt über eine klassische C-C-Kopplungsreaktionen miteinander kombiniert werden können.

Die Synthese der allgemeinen Verbindung (I) kann nach einer der im Folgenden beschriebenen Methoden erfolgen.

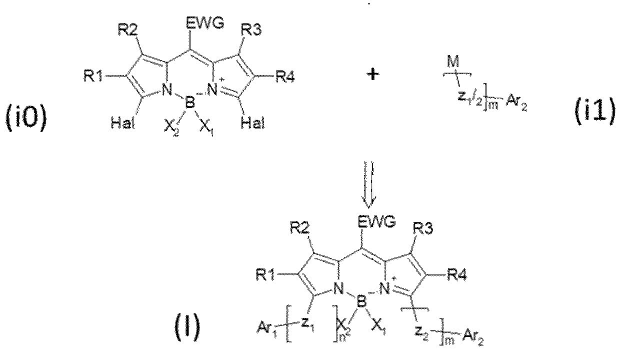

Diese soll hier als beispielhafte Darstellung dienen und kann in der Reihenfolge ihrer einzelnen Schritte variiert, oder durch andere bekannte Methoden abgewandelt werden. Auch die Zusammenfassung einzelner Reaktionsschritte oder die Veränderung von Teilen der Syntheseroute ist möglich.

Der Substituent Hal steht für eine in Kreuzkupplungsreaktionen verwendbare funktionelle Gruppe, wie beispielsweise Carbonsäuren oder Triflate, einschließlich -H. Bevorzugt steht der Substituent Hal für eine Halogenkomponente, bei der es sich typischerweise um ein Halogenatom, bevorzugt Cl, Br oder I, handelt.

Der Substituent M steht für eine in Kreuzkupplungsreaktionen verwendbare funktionelle Gruppe einschließlich -H. Bevorzugt steht der Substituent M für eine Metallkomponente, als eine im weiteren Sinne metall- oder halbmetallhaltige funktionelle Gruppe. Die Gruppe M kann insbesondere ausgewählt sein aus einer der folgenden funktionellen Gruppen:

-SnR*₃, -B(OR*)₂, -Zn-Hal*, -Mg-Hal*,

wobei es sich bei R* um ein Alkyl, bevorzugt ein C1-C10-Alkyl, handelt und wobei die zwei OR* einen Zyklus mit B bilden können und
wobei es sich bei der Gruppe Hal* um ein Halogen handelt, insbesondere ausgewählt aus der Gruppe: Cl, Br, oder I.

Somit kann die Synthese von Verbindungen des Typs (I) beispielsweise durch die Kopplung zweier Bausteine (i0) und (i1) erfolgen.

Die Bereitstellung des Bausteines (i0) ausgehend von kommerziell zugänglichen Materialien beinhaltet die Syntheseschritte Kondensation, Halogenierung, Oxidation und Komplexierung.

Die Reihenfolge dieser vier Einzelschritte ist variierbar und der Fachmann wird diese den Erfordernissen des jeweiligen Substitutionsmusters entsprechend anpassen. Üblicherweise können mehrere Stufen in einen einzigen Reaktionsschritt zusammengefasst werden, ohne dass ein Intermediat dabei isoliert oder gereinigt werden muss ("Eintopfverfahren"oder "Teleskopierung"). Die im Folgenden beschriebene Reaktionssequenz ist daher nur beispielhaft zu verstehen und kann vom Fachmann entsprechend variiert werden.

Alternativ ist die Bereitstellung des Bausteins (I) auch durch Kupplung der Bausteine (i0') und (i1) mit anschließender Komplexierung möglich, wobei der Baustein (i0') durch die beliebige Reihenfolge der Syntheseschritte: Kondensation, Halogenierung, und Oxidation synthetisiert wird.

Die Möglichkeit einer konvergenten Syntheseroute basierend auf einem Baukastenprinzip und über etablierte C-C-Kopplungsreaktionen, 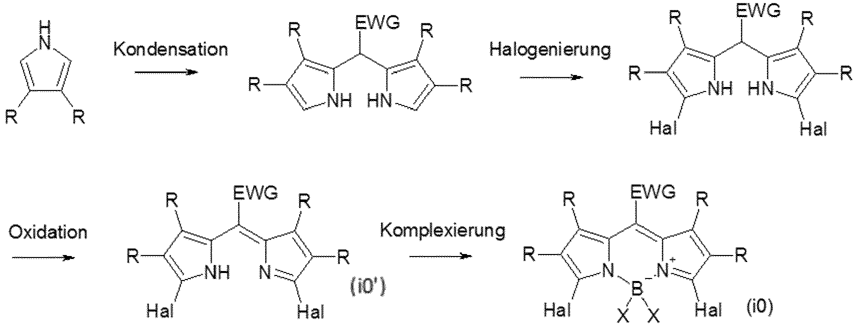 erlaubt einen wirtschaftlichen Zugang zu dieser Materialklasse. Dies stellt einen wesentlichen Vorteil gegenüber anderen in der Literatur beschriebenen Materialklassen dar, deren Verwendung als Nahinfrarotabsorber in organischen elektronischen Bauelementen vorgeschlagen wird.

So beschreiben die Autoren der WO 2014 206 860 A1 ein halbleitendes Bauelement, enthaltend Materialien aus der Klasse der Dipyrromethen-Farbstoffe, welche annelierte Ringe enthalten. Nach WO 2007 126 052 A1 erfolgt die Synthese dieser Materialien über eine vielstufige, lineare Syntheseroute. Beispielsweise erfolgt die Synthese der Verbindung 8 der WO 2007 126 052 A1 über neun lineare Einzelschritte, wobei über die letzten drei Schritte eine Gesamtausbeute von lediglich 8.2% angegeben wird.

Darüber hinaus ist im Stand der Technik die Verwendung von organischen Aziden erforderlich. Die Verwendung von Aziden, sowie eine verhältnismäßig lange, lineare Syntheseroute und niedrige Ausbeuten erschweren in Summe die wirtschaftliche Bereitstellung dieser Materialklasse im technischen Maßstab erheblich.

Die erfindungsgemäßen Materialien sind hingegen über eine konvergente Syntheseroute und einer überschaubaren Anzahl von Einzelschritten in mittleren bis sehr guten Ausbeuten zugänglich.

### Herstellung

Nachfolgend sind die einzelnen Herstellungsschritte der erfindungsgemäßen Verbindungen 1-N angegeben.

### Verbindung A:

Verbindung A wurde nach der Literaturvorschrift Li, L. u.a.: Bioorganic & Medicinal Chemistry Letters (2008), 18(10), 3112-3116 hergestellt.

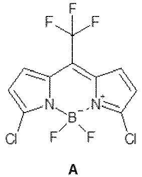

### Verbindung B und Verbindung C:

Die Verbindungen **B** und **C** wurde nach der Literaturvorschrift Paegle, E.: European Journal of Organic Chemistry (2015), 2015, (20), 4389-4399 hergestellt.

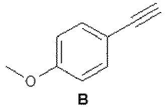

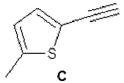

### Allgemeine Arbeitsvorschrift AA1: Suzuki Kreuzkupplungsreaktion

Eine Lösung aus Arylhalogenid (1 Äquivalent), der entsprechenden Furan-2-boronsäure (1.2 Äquivalente) und Kaliumcarbonat (2.5 Äquivalente) in einer Mischung aus Dioxan (1 mL/mmol): Wasser (0,3 mL/mmol) wird in einem Dreihalskolben, ausgestattet mit Rückflusskühler, für 20 Minuten im Argonstrom entgast. Pd(dppf)2Cl2 (5mol%) wird hinzugegeben und die Mischung für 16 h bei 100°C gerührt. Nach dem Abkühlen auf Raumtemperatur werden Wasser und Dichlormethan zugegeben und die Phasen getrennt. Die organische Phase wird drei Mal mit Wasser gewaschen, die wässrige Phase wird drei Mal mit Dichlormethan extrahiert. Die vereinigten organischen Phasen werden über wasserfreiem Natriumsulfat getrocknet und die Lösungsmittel im Vakuum abdestilliert. Das Rohprodukt wird säulenchromatographisch gereinigt (Stationäre Phase: Kieselgel, Laufmittel: Petrolether).

### Allgemeine Arbeitsvorschrift AA2: Stannylierung

Im Dreihalskolben werden bei -78°C zu einer mit Argon inertisierten Lösung der entsprechenden Arylverbindung (1 Äquivalent) in trockenem THF (2 mL/mmol) 1.2 Äquivalente n-Butyllithium (als Lösung in Hexan) zugetropft. Die Mischung wird 2h bei -78°C gerührt und anschließend 1.2 Äquivalente Tributylzinnchlorid oder eine 1M Lösung von Trimethylzinnchlorid in THF zugetropft. Die Mischung wird unter Rühren innerhalb einer Stunde auf Raumtemperatur erwärmt. Anschließend werden Wasser und Dichlormethan zugegeben und die Phasen getrennt. Die organische Phase wird drei Mal mit Wasser gewaschen, die wässrige Phase wird drei Mal mit Dichlormethan extrahiert. Die vereinigten organischen Phasen werden über wasserfreiem Natriumsulfat getrocknet und die Lösungsmittel im Vakuum abdestilliert. Die so gewonnenen Materialien werden ohne weiteren Reinigungsschritt in den Folgereaktionen eingesetzt.

### Allgemeine Arbeitsvorschrift AA3: Stille-Kreuzkupplungsreaktion

1 Äquivalent der Verbindung **A** und 2.2 Äquivalente der entsprechenden nach A**A2** stannylierten Arylverbindung werden in einem Reaktionskolben, ausgestattet mit Rückflusskühler, unter Argonatmosphäre in Toluol (20 mL/mmol) gelöst und 0.1 Äquivalent Pd(PPh₃)₄ zugegeben. Die Mischung wird für die Dauer von 2h bei 80°C gerührt. Nach dem Abkühlen wird das Lösungsmittel unter Vakuum abdestilliert. Das so erhaltene Rohprodukt wird mehrfach mit Hexan gewaschen und aus Toluol umkristallisiert. Gegebenenfalls kann zur weiteren Reinigung eine zweite Kristallisation aus Dichlormethan/Ethanol erfolgen.

### Allgemeine Arbeitsvorschrift AA4: Hydrostannylierung

Ein Äquivalent des terminalen Alkins wird unter Argonatmosphäre in Toluol (5 mL/mmol) gelöst. 0.01 Äquivalente Pd2(dba)3, 0.04 Äquivalente Tricyclohexylphosphin und 4 Äquivalente N-Ethyldiisopropylamin werden nacheinander zugegeben. In einem weiteren Reaktionsgefäß werden 1.2 Äquivalente Tributylstannylhydrid unter Argonatmosphäre mit 3 mL Toluol verdünnt. Diese Lösung wird tropfenweise bei 0°C zur Reaktionsmischung gegeben. Man lässt unter Rühren über Nacht auf Raumtemperatur auftauen. Anschließend wird über ein Bett Celite filtriert und das Lösungsmittel des Filtrats unter Vakuum abdestilliert. Das so erhaltene Material wurde ohne weitere Reinigungsschritte in die Folgereaktion eingesetzt.

### Verbindung D

Verbindung D wird entsprechend der allgemeinen Arbeitsvorschrift AA1 ausgehend von Brombenzol hergestellt. Verbindung D wird als farbloses Öl in 79% Ausbeute erhalten.

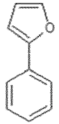

¹H NMR (400 MHz, CDCl₃): δ (ppm) = 7.70-7.67 (m, 2H), 7.48 (dd, ³J = 1.8 Hz, ⁴J = 0.7 Hz, 2H), 7.42-7.37 (m, 2H), 7.26 (tt, ³J = 7.4 Hz, ³J = 1,2 Hz, 1H), 6.66 (dd, ³J = 3.3 Hz, ⁴J = 0.7 Hz, 1H), 6.49-6.47 (m, 1H).

### Verbindung E

Verbindung **E** wird entsprechend der allgemeinen Arbeitsvorschrift **AA1** ausgehend von p-Bromtoluol hergestellt. Verbindung **E** wird als farbloses Öl in 55% Ausbeute erhalten.

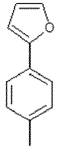

¹H NMR (400 MHz, CDCl₃): δ (ppm) = 7.57 (d, ³J = 8.2 Hz, 2H), 7.46-7.44 (m, 1H), 7.19 (d, ³J = 8.1 Hz, 2H), 6.59 (d, ³J = 3.4 Hz, 1H), 6.47-6.45 (m, 1H), 2.36 (s, 3H).

### Verbindung F

Verbindung **F** wird entsprechend der allgemeinen Arbeitsvorschrift **AA1** ausgehend von 2,4-Dimethylbrombenzol hergestellt. Verbindung **F** wird als farbloses Öl in 59% Ausbeute erhalten.

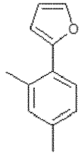

¹H NMR (400 MHz, CDCl₃): δ (ppm) = 7.58 (d, ³J = 8.4 Hz, 1H), 7.49 (t, ³J = 1.2 Hz, 1H), 7.09-7.04 (m, 2H), 6.48-6.50 (m, 2H), 2.47 (s, 3H), 2.35 (s, 3H).p

### Verbindung G

Verbindung **G** wird entsprechend der allgemeinen Arbeitsvorschrift **AA1** ausgehend von 2,4,6-Trimethylbrombenzol hergestellt. Verbindung **G** wird als farbloser Feststoff in 57% Ausbeute erhalten.

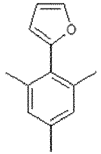

¹H NMR (400 MHz, CDCl₃): δ (ppm) = 7.51 (dd, ³J = 1.8 Hz, ³J = 0.7 Hz, 1H), 6.93 (s, 2H), 6.50-6.48 (m, 1H), 6.26 (dd, ³J = 3.2 Hz, ³J = 0.6 Hz, 1H), 2.32 (s, 3H), 2.18 (s, 6H).

### Verbindung H

Verbindung **H** wird entsprechend der allgemeinen Arbeitsvorschrift **AA1** ausgehend von p-Bromanisol hergestellt. Verbindung **H** wird als farbloses Öl in 88% Ausbeute erhalten.

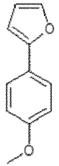

¹H NMR (400 MHz, CDCl₃): δ (ppm) = 7.61 (d, ³J = 8.8 Hz, 2H), 7.43 (s, 1H), 6.93 (d, ³J = 8.8 Hz, 2H), 6.52 (d, ³J = 2.8 Hz, 1H), 6.46-6.44 (m, 1H), 3.84 (s, 3H).

### Verbindung I

Verbindung **I** wird entsprechend der allgemeinen Arbeitsvorschrift **AA1** ausgehend von 2-Brom-5-methylthiophen hergestellt. Verbindung **I** wird als farbloses Öl in 36% Ausbeute erhalten.

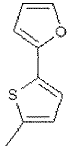

¹H NMR (400 MHz, CDCl₃): δ (ppm) = 7.38-7.36 (m, 1H), 7.03 (d, ³J = 3.6 Hz, 1H), 6.69-6.67 (m, 1H), 6.43-6.39 (m, 2H), 2.49 (s, 3H).

### Verbindung J

Verbindung **J** wird entsprechend der allg. Arbeitsvorschrift **AA2** ausgehend von Verbindung **D** hergestellt. Es wird ein Rohprodukt erhalten, das zu 50% aus Verbindung **D** und zu 50% aus Verbindung **J** besteht.

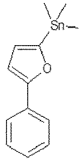

¹H NMR (400 MHz, CDCl₃): δ (ppm) = 7.71-7.66 (m, 2H), 7.41-7.35 (m, 2H), 7.29-7.21 (m, 1H), 6.69-6.63 (M, 2H), 0.37 (s, 9H).

### Verbindung K

Verbindung K wird entsprechend der allgemeinen Arbeitsvorschrift AA2 ausgehend von Verbindung E hergestellt. Verbindung K wird in 90% Ausbeute erhalten.

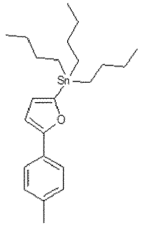

¹H NMR (400 MHz, CDCl₃): δ (ppm) = 7.57 (d, ³J = 8.4 Hz, 2H), 7.17 (d, ³J = 8.4 Hz, 2H), 6.63-6.59 (m, 2H), 2.36 (s, 3H), 1.64-1.55 (m, 6H), 1.39-1.32 (m, 6H), 1.14-1.08 (m, 6H), 0.94-0.87 (m, 9H).

### Verbindung L

Verbindung **L** wird entsprechend der allgemeinen Arbeitsvorschrift **AA2** ausgehend von Verbindung **F** hergestellt. Verbindung **L** wird in 95% Ausbeute erhalten.

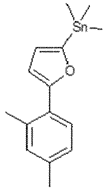

¹H NMR (400 MHz, CDCl₃): δ (ppm) = 7.60 (d, ³J = 8.4 Hz, 2H), 7.08-7.04 (m, 2H), 6.68 (d, ³J = 3.2 Hz, 1H), 6.52 (d, ³J = 3.2 Hz, 1H), 2.47 (s, 3H), 2.44 (s, 3H), 0.37 (s, 9H).

### Verbindung M

Verbindung **M** wird entsprechend der allgemeinen Arbeitsvorschrift **AA2** ausgehend von Verbindung **G** hergestellt. Verbindung **M** wird in 95% Ausbeute erhalten.

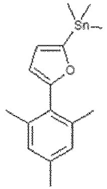

¹H NMR (400 MHz, CDCl₃): δ (ppm) = 6.93 (s, 2H), 6.67 (d, ³J = 3.2 Hz, 1H), 6.29 (d, ³J = 3.2 Hz, 1H), 2.31 (s, 3H), 2.19 (s, 6H), 0.33 (s, 9H).

### Verbindung N

Verbindung **N** wird entsprechend der allgemeinen Arbeitsvorschrift **AA2** ausgehend von Verbindung **H** hergestellt. Verbindung **N** wird in 99% Ausbeute erhalten.

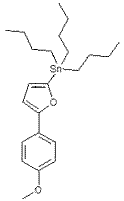

¹H NMR (400 MHz, CDCl₃): δ (ppm) = 7.60 (d, ³J = 8.8 Hz, 2H), 6.91 (d, ³J = 8.8 Hz, 2H), 6.59 (d, ³J = 2.8 Hz, 1H), 6.54 (d, ³J = 3.2 Hz, 1H), 3.39 (s, 3H), 1.63-1.57 (m, 6H), 1.39-1.32 (m, 6H), 1.13-1.07 (m, 6H), 0.93-0.87 (m, 9H).

### Verbindung O

Verbindung **O** wird entsprechend der allgemeinen Arbeitsvorschrift **AA2** ausgehend von Verbindung **I** hergestellt. Verbindung **O** wird in 95% Ausbeute erhalten.

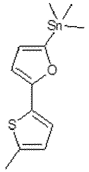

¹H NMR (400 MHz, CDCl₃): δ (ppm) = 7.04 (d, ³J = 3.6 Hz, 1H), 6.68-6.66 (m, 1H), 6.59 (d, ³J = 3.2 Hz, 2H), 6.42 (d, ³J = 3.2 Hz, 1H), 2.48 (s, 3H), 0.35 (s, 9H).

### Verbindung P

Verbindung **P** wird entsprechend der allgemeinen Arbeitsvorschrift **AA4** ausgehend von 4-Methoxyphenylethin hergestellt.

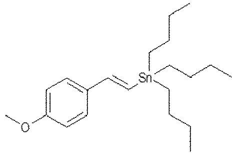

¹H NMR (400 MHz, CDCl₃): δ (ppm) = 7.36 (d, ³J = 8.8 Hz, 2H), 6.86 (d, ³J = 8.8 Hz, 2H), 6.82 (d, ³J = 19.6 Hz, 1H), 6.66 (d, ³J = 19.6 Hz, 1H), 3.81 (s, 3H), 1.57-1.44 (m, 6H), 1.39-1.27 (m, 6H), 0.98-0.86 (m, 15H).

### Verbindung Q

Verbindung **Q** wird entsprechend der allgemeinen Arbeitsvorschrift **AA4** ausgehend von 5-Methyl-2-thienylethin hergestellt.

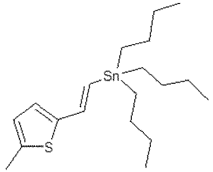

¹H NMR (400 MHz, CDCl₃): δ (ppm) = 6.85 (d, ³J = 19.2 Hz, 1H), 6.68 (d, ³J = 3.2 Hz, 1H), 6.61-6.59 (m, 1H), 6.41 (d, ³J = 19.2 Hz, 1H), 2.45 (s, 3H), 1.55-1.48 (m, 6H), 1.38-1.28 (m, 6H), 0.96-0.85 (m, 15H).

### Verbindung R

Verbindung **R** wird entsprechend der allg. Arbeitsvorschrift **AA2,** ausgehend von Benzofuran hergestellt. Verbindung R wird in 97% Ausbeute erhalten.

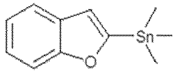

¹H NMR (400 MHz, CDCl₃): δ (ppm) = 7.57-7.53 (m, 1H), 7.52-7.48 (m, 1H), 7.26-7.16 (m, 2H), 6.93 (d, ³J = 0.9 Hz, 1H), 0.41 (s, 9H).

### Verbindung S

Verbindung **S** wird entsprechend der allgemeinen Arbeitsvorschrift **AA1,** ausgehend von Verbindung **R** hergestellt. Verbindung **S** wird in 58% Ausbeute als farbloses Öl erhalten.

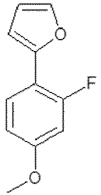

¹H NMR (400 MHz, CDCl₃): δ (ppm) = 7.64 (t, ³J = 8.8 Hz, 1H), 7.38 (d, ³J = 1.2 Hz, 1H), 6.68 (ddd, ³J = 8.8 Hz, ⁴J = 2.8 Hz, ⁴J = 2.0 Hz, 1H), 6.63-6.58 (m, 2H), 6.43-6.41 (m, 1H), 3.75 (s, 3H).

### Verbindung T

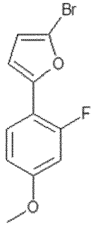

Verbindung **S** (5.09 mmol) wird in 30 mL DMF gelöst. Die Lösung wird auf 0°C abgekühlt und eine Lösung von 5.6 mmol NBS in 20 mL DMF wird zugetropft. Nach dem Auftauen auf R.T. wird 16h gerührt. Anschließend werden Wasser und Dichlormethan zugegeben und die Phasen getrennt. Die organische Phase wird drei Mal mit Wasser gewaschen, die wässrige Phase wird drei Mal mit Dichlormethan extrahiert. Die vereinigten organischen Phasen werden über wasserfreiem Natriumsulfat getrocknet und die Lösungsmittel im Vakuum abdestilliert. Das Rohprodukt wird säulenchromatographisch gereinigt (Stationäre Phase: Kieselgel, Laufmittel: Petrolether). Verbindung **T** wird in 66% Ausbeute als weißer Feststoff erhalten, der sich unter Lichteinwirkung schwarz verfärbt.

¹H NMR (400 MHz, CDCl₃): δ (ppm) = 7.68 (t, ³J = 8.8 Hz, 1H), 6.74 (dd, ³J = 8.8 Hz, ⁴³J = 2.8 Hz, 1H), 6.70-6.62 (m, 2H), 6.41-6.38 (m, 1H), 3.83 (s, 3H)

### Verbindung U

Verbindung **U** wird entsprechend der allgemeinen Arbeitsvorschrift **AA2,** ausgehend von Verbindung **T** hergestellt. Verbindung **U** wird in 89% Ausbeute erhalten. ¹H NMR (400 MHz, CDCl₃): δ (ppm) = 7.77 (t, ³J = 8.8 Hz, 1H), 6.78-6.65 (m, 4H), 3.83 (s, 3H), 0.37 (s, 9H).

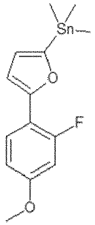

### Verbindung V

Verbindung **V** wurde nach der Literaturvorschrift Seitz, D. E.; Lee, S.-H.; Hanson, R. N.; Bottaro, J. C. Synth. Comm. 1983, 13, 121-128. Hergestellt.

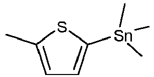

### Verbindung W

Verbindung **W** wird entsprechend der allg. Arbeitsvorschrift **AA3,** ausgehend von Verbindung **V** hergestellt. Verbindung **W** wird in 99% Ausbeute erhalten nach chromatographischer Reinigung.

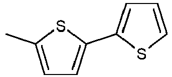

### Verbindung X

Verbindung **X** wird entsprechend der allgemeinen Arbeitsvorschrift **AA2** ausgehend von Verbindung **W** hergestellt und in 93% Ausbeute erhalten.

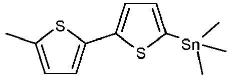

¹H NMR (400 MHz, CDCl₃): δ (ppm) = 7.20 (d, ³J = 3.3 Hz, 1H), 7.07 (d, ³J = 3.3 Hz, 1H), 6.96 (d, ³J = 3.5 Hz, 2H), 6.66-6.65 (m, 1H), 2.48 (s, 3H), 0.38 (s, 9H).

Die als Ausführungsbeispiel gezeigten erfindungsgemäßen und nichterfindungsgemäßen Verbindungen, dargestellt als Strukturen 1 bis 12, werden entsprechend der allgemeinen Arbeitsvorschrift **AA3** hergestellt.

**Tabelle 1**

| **Struktur** | **Ausgangsstoffe** | **Ausbeute** | **¹H-NMR (400MHz)** |
|---|---|---|---|
| **1** | **A,** Furan-2-boronsäure | 46% | (CDCl₃): δ (ppm) = 7.81 (d, ³J = 3.6 Hz, 2H), 7.65 (d, ³J = 2.0 Hz, 2H), 7.35-7.31 (m, 2H), 7.10 (d, 3J = 4.4 Hz, 2H), 6.68 (m, 2H) |
| **2** | **A, J** | 52% | (C₂D₂Cl₄, 373 K): δ (ppm) = 7.90-7.86 (m, 6H), 7.51 (t, ³J = 5.6 Hz, 4H), 7.45-7.38 (m, 4H), 7.25 (d, ³J = 4.0 Hz, 2H), 7.01 (d, ³J = 3.2 Hz, 4H) |
| **3** | **A, K** | 38% | (C₂D₂Cl₄, 373 K): δ (ppm) = 7.87 (d, ³J = 3.2 Hz, 2H), 7.77 (d, ³J = 6.8 Hz, 4H), 7.40-7.36 (m, 2H), 7.31 (d, ³J = 6.4 Hz, 4H), 7.23 (d, ³J = 3.6 Hz, 2H), 6.95 (d, ³J = 2.8 Hz, 2H), 2.47 (s, 6H) |
| **4** | **A, M** | 59% | (C₂D₂Cl₄, 373 K): δ (ppm) = 7.98 (m, 2H), 7.36 (m, 2H), 7.16 (m, 2H), 7.02 (s, 4H), 6.66 (d, ³J = 2.8 Hz, 2H), 2.39 (s, 6H), 2.35 (s, 12H) |
| **5** | **A, L** | 51% | (C₂D₂Cl₄, 373 K): δ (ppm) = 7.93 (d, ³J = 3.2 Hz, 2H), 7. 7 6 (d, ³J = 6.8 Hz, 2H), 7.40-7.37 (m, 2H), 7.21 (d, ³J = 3.6 Hz, 2H), 7.19-7.15 (m, 4H), 6.88 (d, ³J = 3.2 Hz, 2H), 2,64 (s, 6H), 2.44 (s, 6H) |
| **6** | **A, N** | 37% | (DMSO, 373 K): δ (ppm) = 7.93 (d, ³J = 9.8 Hz, 4H), 7.85 (d, ³J = 2.8 Hz, 2H), 7.46-7.39 (m, 4H), 7.25 (d, ³J = 3.2 Hz, 2H), 7.08 (d, ³J = 7.2 Hz, 2H), 3.88 (s, 6H) |
| **7** | **A, Q** | 33% | (C₂D₂Cl₄, 373 K): δ (ppm) = 7.49 (d, ³J = 15.2 Hz, 2H), 7.46 (d, ³J = 15.6 Hz, 2H), 7.33-7.29 (m,2 H), 7.19 (d, ³J = 2.8 Hz, 2H), 6.99 (d, ³J = 3.6 Hz, 2H), 6.83-6.81 (m, 2H), 2.60 (s, 6H) |
| **8** | **A, O** | 42% | (C₂D₂Cl₄, 373 K): δ (ppm) = 7.85 (d, ³J = 3.2 Hz, 2H), 7.37-7.34 (m, 2H), 7.33 (d, ³J = 2.8 Hz, 2H), 7.18 (d, ²J = 3.6 Hz, 2H), 6.84-6.81 (m, 2H), 6.76 (d, ³J = 2.8 Hz, 2H), 2.60 (s, 6H) |
| **9** | **A, P** | 33% | (CDCl₃, 373K): δ (ppm) = 7.64 (d, ³J = 16.4 Hz, 2H), 7.62 (d, ³J = 8.8 Hz, 4H), 7.38 (d, ³J = 16,4 Hz, 2H), 7.29-7.26 (m, 2H), 6.99 (d, ³J = 4.4 Hz, 2H), 6.96 (d, ³J = 8.8 Hz, 4H), 3.87 (s, 6H) |
| **10** | **A, U** | 35% | (C₂D₂Cl₄, 373 K): δ (ppm) = 7.95 (t, ³J = 8.5 Hz, 2H), 7.86 (d, ³J = 3.5 Hz, 2H), 7.38 (s, 2H), 7.21 (d, ³J = 4.5 Hz, 2H), 7.04 (t, ³J = 3.5 Hz, 2H), 6.87 (dd, ³J = 8.5 Hz, ⁴J = 2.5 Hz, 2H), 6.80 (dd, ³J = 12.5 Hz, ⁴J = 2 Hz, 2H), 6.56 (s, 6H) |
| **11** | **A, R** | 39% | (C₂D₂Cl₄, 373 K): δ (ppm) = 8.25 (s, 2H), 7.84 (d, ³J = 6.4 Hz, 2H), 7.61 (d, ³J = 6.8 Hz, 2H), 7.53-7.47 (m, 4H), 7.41-7.36 (m, 4H). |
| **12** | **A, X** | 37% | (C₂D₂Cl₄, 373 K): δ (ppm) = 8.17 (d, ³J = 3.2 Hz, 2H), 7.36 (s, 2H), 7.27 (d, ³J = 3.3 Hz, 2H), 7.20 (d, ³J = 2.8 Hz, 2H), 6.97 (d, ³J = 3.6 Hz, 2H), 6.79 (d, ³J = 2.8 Hz, 2H), 2.57 (s, 6H). |

### Ausführungsbeispiele

Es konnte gezeigt werden, dass die erfindungsgemäßen Strukturen / Verbindungen eine hohe thermische Stabilität aufweisen und im Vakuum verdampft werden können. Überraschenderweise wurde gefunden, dass Filme der erfindungsgemäßen Verbindungen besonders breit im nahinfraroten, für das menschliche Auge nicht mehr sichtbaren Bereich oberhalb von 650 / 700 nm absorbieren.

In diesem Zusammenhang zeigt die folgende Tabelle die Absorptionsmaxima und die Halbwertsbreiten von 30nm dicken, vakuumgedampften Filmen der erfindungsgemäßen Verbindungen. Die Erfinder verstehen unter Halbwertsbreite die Differenz zwischen den beiden Wellenlängen, für die die Absorptionsmaxima auf die Hälfte des Maximums abgesunken sind.

### Vergleichsmaterial V1

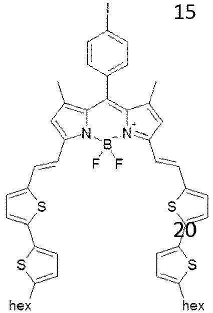

[Bura et al., J. Am. Chem. Soc. 2012, 134, 17404-17407]: Das Vergleichsmaterial **V1** lässt sich nicht unzersetzt im Hochvakuum verdampfen. Es gelingt somit nicht, mit **V1** vakuumprozessierte Bauelemente herzustellen.

### Vergleichsmaterial V2

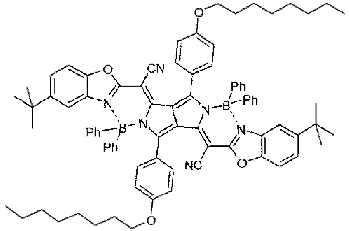

Der in WO 2015 036 529 beschriebene NIR-Absorber für vakuumprozessierte Solarzellen (Vergleichsmaterial **V2)** absorbiert im Film bei 781nm.

Aufgrund des sehr schmalen Absorptionsbereichs (Halbwertsbreite von 55nm) kann aber nur ein sehr kleiner spektraler Bereich für die optoelektronische Umwandlung genutzt werden.

### Vergleichsmaterial V3

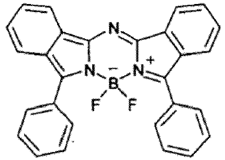

Bei dem in WO 2010 133 208 A1 genannten Vergleichsmaterial **V3** handelt es sich den Autoren zufolge um ein im roten und nahinfraroten Bereich absorbierendes Material. Es wird ein halbleitendes Bauelement unter Verwendung von Verbindungen dieses Typs beschrieben. Vergleicht man die dort gezeigten Kenndaten des Vergleichsmaterials **V3** mit den erfindungsgemäßen Verbindungen in einer vakuumprozessierten Mischschicht-Solarzelle, so wird die Überlegenheit der erfindungsgemäßen Verbindungen insbesondere beim generierten Photostrom deutlich.

**Tabelle 2**

| **Verbindung** | **Absorptionsmaximum [nm]** | **Halbwertsbreite [nm]** |
|---|---|---|
| 1 | 795 | 235 |
| 2 | 839 | 234 |
| 3 | 849 | 226 |
| 4 | 769 | 155 |
| 5 | 849 | 228 |
| 6 | 869 | 220 |
| 7 | 816 | 214 |
| 8 | 887 | 257 |
| 9 | 781 | 185 |
| 10 | 916 | 248 |
| 11 | 640 | 142 |
| 12 | 788 | 184 |
| V1 | Nicht im Vakuum verdampfbar | |
| V2 | 781 | 55 |
| V3 | | |

Von einzelnen Verbindungen wurden weiterhin vakuumprozessierte Solarzellen angefertigt. Die folgende Tabelle 3 zeigt verschiedene Parameter dieser Serie von Materialien im direkten Vergleich. Die photovoltaischen Parameter Voc, Jsc und FF beziehen sich jeweils auf Solarzellen mit 30nm dicker Mischschicht aus dem jeweiligen Donormaterial dieser Verbindungen und Fulleren C60 als photoaktive Schicht auf Glas mit dem Aufbau ITO/ C60/ den jeweiligen Verbindungen:C60/ HTMX/ HTMX:DPY / DPY/ Au, gemessen unter AM1.5 Beleuchtung (Am = Air Mass AM = 1,5 bei diesem Spektrum beträgt die globale Strahlungsleistung 1000 W/m²; AM = 1,5 als Standardwert für die Vermessung von Solarmodulen), wobei HTMX ein Lochtransportmaterial ist und DPY ein Dotand ist.

ITO dient in diesen Testbeispielen als Anode, und das benachbarte Fulleren C60 als Elektronentransportschicht (ETL), daran schließt sich die photoaktive Schicht als Volumenheteroübergang von C60 als Elektronenakzeptormaterial und der jeweiligen Verbindung als Lochakzeptormaterial (Donatormaterial) an, gefolgt von HTX als Lochtransportschicht (HTL = hole transport layer) und mit DPY dotiertem HTMX und einer DPY-Schicht gefolgt von einer Au-Kathode.

**Tabelle 3**

| **Verbindung** | **Voc [V]** | **Jsc [mA/cm²]** | **FF [%]** | **Eff [%]** |
|---|---|---|---|---|
| 1 | 0,85 | 5,50 | 52,90 | 2,47 |
| 2 | 0,63 | 8,80 | 52,10 | 2,89 |
| 3 | 0,69 | 9,90 | 59,10 | 4,04 |
| 4 | 0,91 | 6,30 | 37,80 | 2,17 |
| 5 | 0,73 | 8,20 | 42,50 | 2,54 |
| 6 (6 nm, planarer Übergang) | 0,53 | 4,50 | 60,40 | 1,44 |
| 7 | 0,70 | 8,70 | 56,80 | 3,46 |
| 8 | 0,43 | 8,10 | 38,00 | 1,32 |
| 9 | 0,70 | 10,30 | 64,20 | 4,63 |
| 10 | 0,58 | 9,60 | 44, 60 | 2,48 |
| V2 | 0,97 | 2,80 | 35,30 | 0,85 |
| V3 | 0,65 | 2,47 | 64, 89 | 1,04 |

Für das Vergleichsmaterial **V2** wurden die in WO 2015 036 529 gelisteten Kenndaten einer vakuumprozessierten Solarzelle herangezogen. Hieraus wir deutlich, dass die erfindungsgemäßen Verbindungen insbesondere aufgrund ihres wesentlich höheren Photostromes überlegen sind. Die in WO 2015 036 529 beschriebene Mischschicht-Solarzelle hat zwar nur eine aktive Schichtdicke von 20 nm, jedoch ist der Photostrom der erfindungsgemäßen Verbindungen um ein vielfaches höher, was nicht alleine durch die um 50% höhere Schichtdicke zu erklären ist. Bei Vergleichsmaterial **V2** wird darüber hinaus beobachtet, dass bei Erhöhung der Schichtdicke von 10 auf 20 nm sowohl FF als auch Photostrom sinken. Bei den erfindungsgemäßen Verbindungen können hingegen auch bei höheren Schichtdicken von 30 nm hohe Füllfaktoren erzielt werden.

## Patentansprüche

1. Chemische Verbindung gemäß der allgemeinen Formel I: 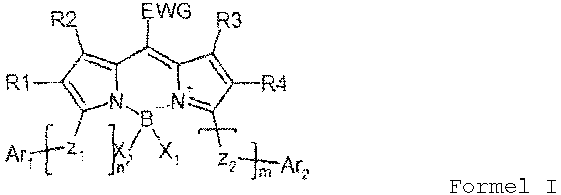
a) mit n, m jeweils unabhängig voneinander 0, 1 oder 2;
b) mit X1, X2 jeweils unabhängig voneinander ausgewählt aus Halogen, CN, Alkyl, fluoriertem oder teilfluoriertem Alkyl, Alkenyl, Alkinyl, Alkoxy, Aryl oder Heteroaryl;
c) mit EWG CF₃;
d) mit z1 und z2 ausgewählt aus den Gruppen (II) bis (IV): 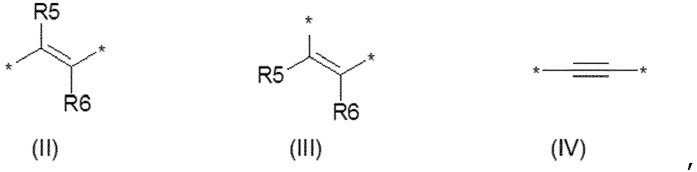 wobei "*" jeweils eine potentielle Anknüpfstelle des Substituenten z1, z2 an das Dipyrringerüst und an die Arylsubstituenten Ar1, Ar2 bezeichnet,
e) mit R1 bis R4 jeweils unabhängig voneinander ausgewählt aus H oder einem Alkyl;
f) mit R5 und R6 jeweils unabhängig ausgewählt aus H, Halogen, CN, einer substituierten oder unsubstituierten, verzweigten oder unverzweigten, linearen oder cyclischen Alkylkette;
g) wobei Ar1 im Falle von n = 0 und/oder Ar2 im Falle von m = 0 der Formel (V) entsprechen, und "*" die Anknüpfstelle des Substituenten Ar1, Ar2 an das Dipyrringerüst bezeichnet, 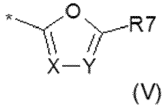 wobei X ausgewählt ist aus N oder C-R8, wobei Y ausgewählt ist aus N oder C-R9 ist, wobei R7 bis R9 unabhängig voneinander ausgewählt sind aus einer Gruppe bestehend aus H, Halogen, verzweigtem oder linearem, zyklischem oder offenkettigem Alkyl oder Aryl, wobei H-Atome und/oder C-Atome des Alkyls oder Aryls substituiert sein können, oder aus einer Gruppe bestehend aus Alkenyl, O-Alkyl, S-Alkyl, O-Alkenyl, S-Alkenyl, Alkinyl, Aryl oder Heteroaryl, wobei bei allen diesen Gruppen H-Atome substituiert sein können, oder aus CN oder NR'R'', mit R' und R" jeweils unabhängig voneinander ausgewählt aus: H, verzweigtem oder linearem, zyklischem oder offenkettigem Alkyl, wobei H- und/oder C-Atome des Alkyls substituiert sein können, oder wobei R7 und R9 zusammen einen homo- oder heterocyclischen, gesättigten oder ungesättigten, substituierten oder unsubstituierten Ring ausbilden können, und
wobei Ar1 im Fall n > 0 und/oder Ar2 im Fall m > 0 ein substituierter oder unsubstituierter heterocyclischer 5-Ring ist, bevorzugt mit Heteroatomen ausgewählt aus S oder O.

2. Chemische Verbindung gemäß Anspruch 1, **dadurch gekennzeichnet, dass** die H-Atome des Alkyls oder Aryls oder Alkenyls oder Alkinyls von R7 bis R9 ganz oder teilweise durch ein Halogen ersetzt sind, vorzugsweise F, und/oder die C-Atome des Alkyls und Aryls durch ein Heteroatom ersetzt sein können, vorzugsweise O oder S.

3. Chemische Verbindung gemäß Anspruch 1 oder 2, **dadurch gekennzeichnet, dass** R1 bis R4 H oder Methyl sind.

4. Chemische Verbindung gemäß einem der vorhergehenden Ansprüche, **dadurch gekennzeichnet, dass** R5 und R6 unabhängig voneinander ausgewählt sind aus H oder einem Alkyl, bevorzugt sind R5 und R6 H.

5. Chemische Verbindung gemäß einem der vorhergehenden Ansprüche, **dadurch gekennzeichnet, dass** X1 und/oder X2 ein Halogen ist, bevorzugt F.

6. Chemische Verbindung gemäß einem der vorhergehenden Ansprüche, **dadurch gekennzeichnet, dass** die Verbindung spiegelsymmetrisch gegenüber der Achse durch EWG und B ist.

7. Chemische Verbindung gemäß einem der vorhergehenden Ansprüche, **dadurch gekennzeichnet, dass** es sich bei der chemischen Verbindung der allgemeinen Formel I um folgende Verbindungen handelt:

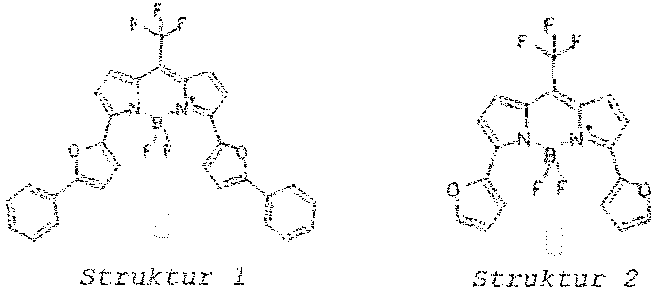

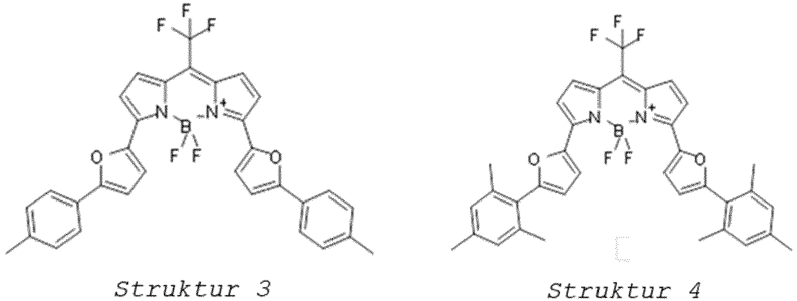

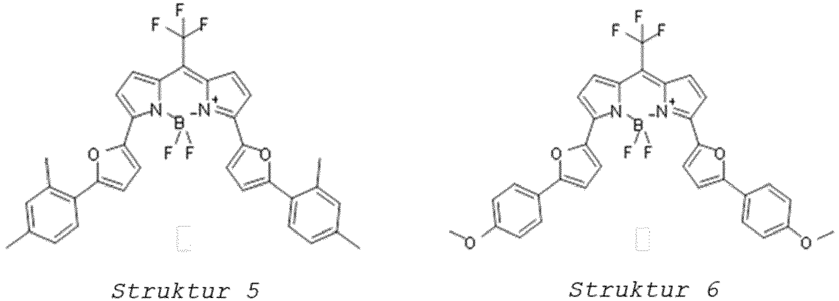

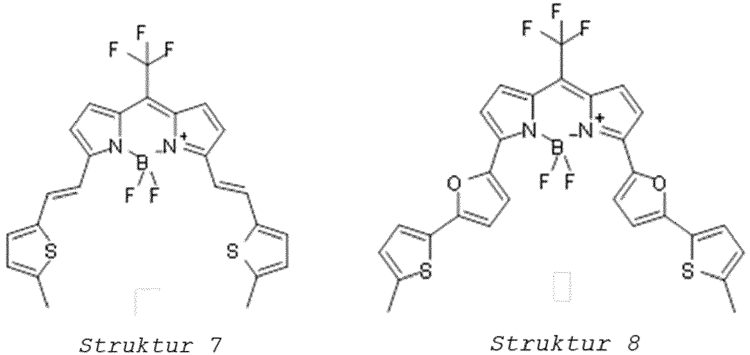

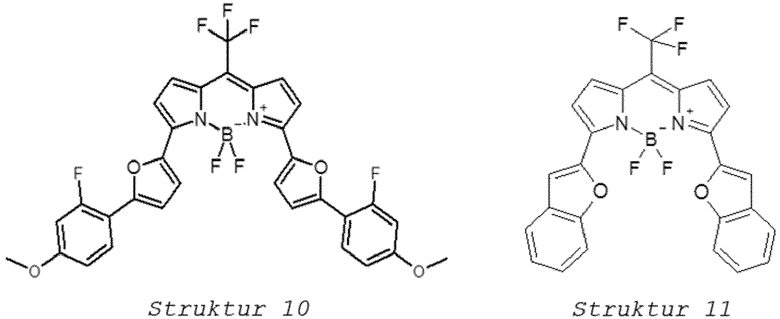

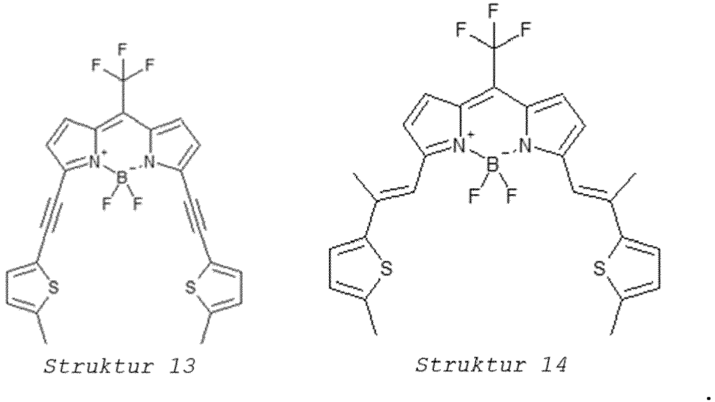

8. Herstellung der chemischen Verbindung gemäß der allgemeinen Formel I gemäß einem der vorhergehenden Ansprüche,
- durch die Kopplung der Bausteine (i0) und (i1) oder
- durch die Kopplung der Bausteine (i0') und (i1) mit anschließender Komplexierung 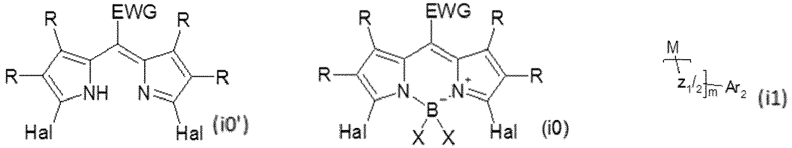 , wobei
a) (i0) durch die beliebige Reihenfolge der Syntheseschritte Kondensation, Halogenierung, Oxidation und Komplexierung synthetisiert wird;
b) (i0') durch die beliebige Reihenfolge der Syntheseschritte Kondensation, Halogenierung und Oxidation synthetisiert wird;
c) Hal ein Halogenatom, oder eine andere in Kreuzkupplungsreaktionen einsetzbare funktionelle Gruppe oder -H, ist, bevorzugt ist Hal ein Halogenatom; und
d) M eine metall- oder halbmetallhaltige funktionelle Gruppe, die in Kreuzkupplungsreaktionen verwendbar ist, oder -H ist, wobei M bevorzugt ausgewählt ist aus -SnR*3, -B(OR*)2, -Zn-Hal*, -Mg-Hal*,
wobei es sich bei R* um ein Alkyl handelt, und die zwei (OR*) einen Zyklus mit B bilden können, und
wobei es sich bei Hal* um ein Halogen handelt, ausgewählt aus der Gruppe Cl, Br, oder I.

9. Verwendung der chemischen Verbindung gemäß einem der vorhergehenden Ansprüche 1 bis 7 oder Verwendung der nach dem vorhergehenden Anspruch hergestellten Verbindung in optoelektronischen Bauelementen, bevorzugt in organischen optoelektronischen Bauelementen, besonders bevorzugt in organischen Solarzellen, OLEDs, oder Photodetektoren.

10. Verwendung gemäß Anspruch 9 in mindestens einer photoaktiven Schicht, d.h. in einer lichtabsorbierenden Schicht, eines organischen optoelektronischen Bauelements als mindestens ein Absorbermaterial dieser photoaktiven Schicht.

11. Organisches optoelektronisches Bauelement umfassend zwei Elektroden, wobei eine als Substratelektrode und eine als Gegenelektrode ausgeführt ist, und zwischen den beiden Elektroden ein Schichtstapel, umfassend mindestens eine Zelle, diese umfassend mindestens eine organische Schicht und mindestens eine Transportschicht, **dadurch gekennzeichnet, dass** die organische Schicht und/oder Transportschicht ein Material gemäß einem der Ansprüche 1 bis 7 umfasst.

## Claims

1. Chemical compound of general formula I: 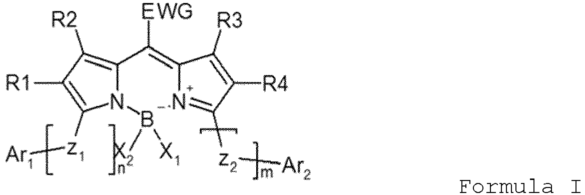
a) where n, m are each independently of one another 0, 1 or 2;
b) where X1, X2 are each independently of one another selected from halogen, CN, alkyl, fluorinated or partially fluorinated alkyl, alkenyl, alkynyl, alkoxy, aryl or heteroaryl;
c) where EWG is CF₃;
d) where z1 and z2 are selected from the groups (II) to (IV) : 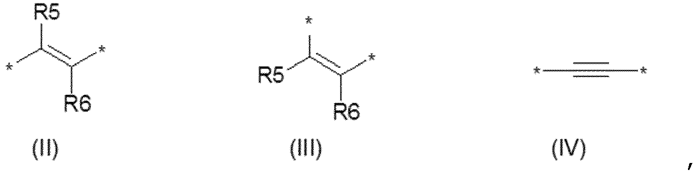 wherein "*" in each case describes a potential bonding site of the substituents z1, z2 to the dipyrrine backbone and to the aryl substituents Ar1, Ar2,
e) where R1 to R4 are each independently of one another selected from H or an alkyl;
f) where R5 and R6 are each independently of one another selected from H, halogen, CN, a substituted or unsubstituted, branched or unbranched, linear or cyclic alkyl chain;
g) wherein Ar1 in the case of n = 0 and/or Ar2 in the case of m = 0 correspond to formula (V) and "*" describes the bonding site of the substituents Ar1, Ar2 to the dipyrrine backbone, 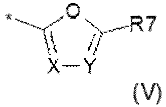 wherein X is selected from N or C-R8, wherein Y is selected from N or C-R9, wherein R7 to R9 are independently of one another selected from a group consisting of H, halogen, branched or linear, cyclic or open-chain alkyl or aryl, wherein H-atoms and/or C-atoms of the alkyl or aryl may be substituted, or from a group consisting of alkenyl, O-alkyl, S-alkyl, O-alkenyl, S-alkenyl, alkynyl, aryl or heteroaryl, wherein in all these groups H-atoms may be substituted, or from CN or NR'R", where R' and R" are each independently of one another selected from: H, branched or linear, cyclic or open-chain alkyl, wherein H- and/or C-atoms of the alkyl may be substituted or wherein R7 and R9 may together form a homocyclic or heterocyclic, saturated or unsaturated, substituted or unsubstituted ring, and
wherein Ar1 in the case of n > 0 and/or Ar2 in the case of m > 0 is a substituted or unsubstituted heterocyclic 5-membered ring, preferably having heteroatom selected from S or O.

2. Chemical compound according to Claim 1, **characterized in that** the H atoms of the alkyl or aryl or alkenyl or alkynyl of R7 to R9, are fully or partially substituted by a halogen, preferably F, and/or the C atoms of the alkyl and aryl may be substituted by a heteroatom, preferably O or S.

3. Chemical compound according to Claim 1 or 2 **characterized in that** R1 to R4 are H or methyl.

4. Chemical compound according to any of the preceding claims, **characterized in that** R5 and R6 are independently of one another selected from H or an alkyl, preferably R5 and R6 are H.

5. Chemical compound according to any of the preceding claims, **characterized in that** X1 and/or X2 is a halogen, preferably F.

6. Chemical compound according to any of the preceding claims, **characterized in that** the compound has mirror symmetry about the axis through EWG and B.

7. Chemical compound according to any of the preceding claims, **characterized in that** the chemical compound of general formula I is selected from the following compounds:

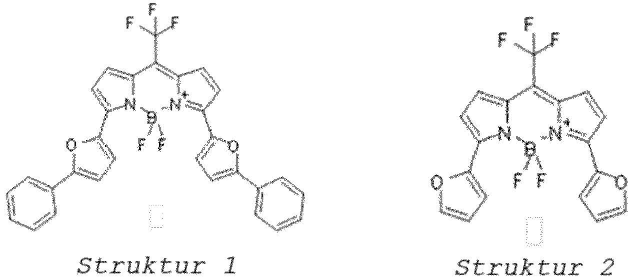

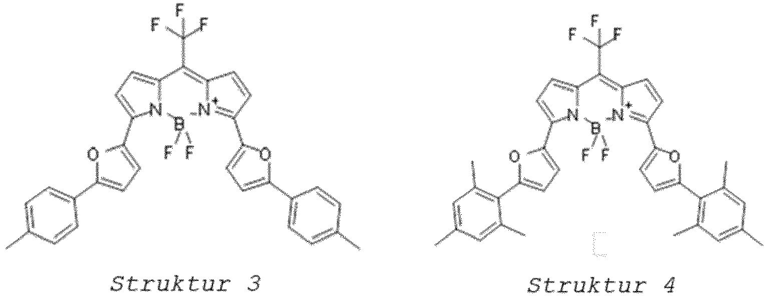

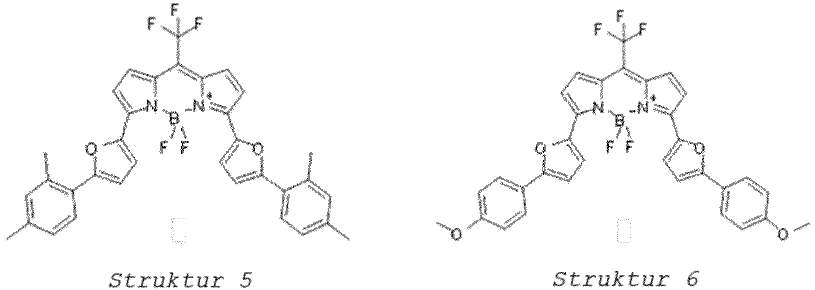

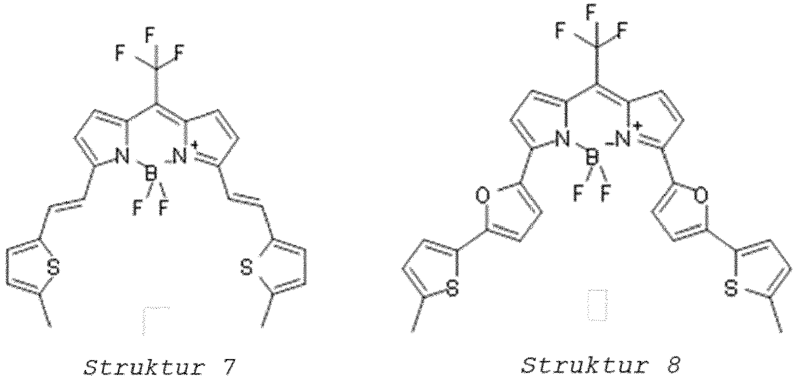

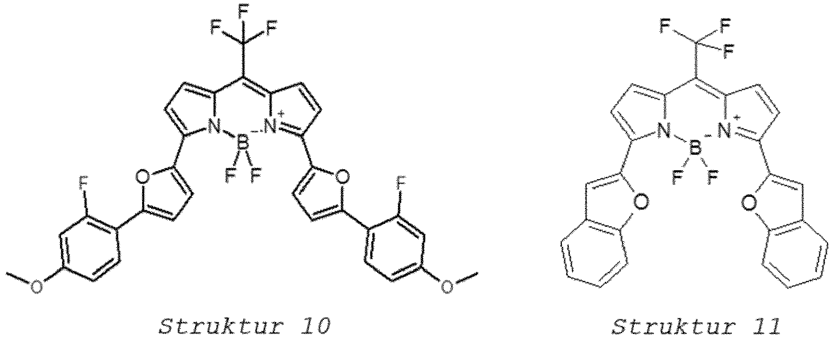

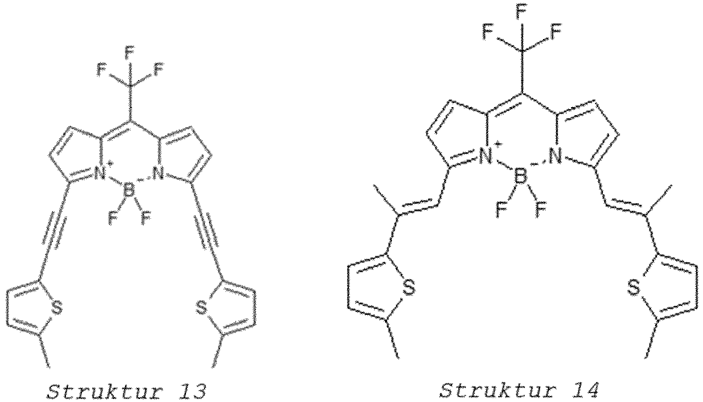

8. Production of the chemical compound of general formula I according to any of the preceding claims,
- through coupling of the units (i0) and (i1) or
- through coupling of the units (i0') and (i1) with subsequent complexation 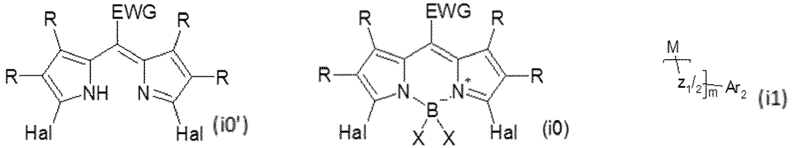 , wherein
a) (i0) is synthesized by any desired sequence of the synthesis steps condensation, halogenation, oxidation and complexation;
b) (i0') is synthesized by any desired sequence of the synthesis steps condensation, halogenation and oxidation;
c) Hal is a halogen atom or another functional group employable in cross-coupling reactions or -H, preferably a halogen atom; and
d) M is a metal- or metalloid-containing functional group employable in cross-coupling reactions or -H, wherein M is preferably selected from -SnR*3, -B(OR*)2, -Zn-Hal*, -Mg-Hal*,
wherein R* is an alkyl and the two (OR*) may form a cycle with B, and
wherein Hal* is a halogen selected from the group of Cl, Br, oder I.

9. Use of the chemical compound according to any of the preceding Claims 1 to 7 or use of the compound produced according to the preceding claim in optoelectronic components, preferably in organic optoelectronic components, particularly preferably in organic solar cells, OLEDs or photodetectors.

10. Use according to claim 9 in at least one photoactive layer, i.e. in a light-absorbing layer, of an organic optoelectronic component as at least one absorber material of this photoactive layer.

11. Organic optoelectronic component comprising two electrodes, wherein one is in the form of a substrate electrode and one is in the form of a counterelectrode, and between the two electrodes a layer stack comprising at least one cell comprising at least one organic layer and at least one transport layer, **characterized in that** the organic layer and/or transport layer comprises a material according to any of claims 1 to 7.

## Revendications

1. Composé chimique de formule générale I: 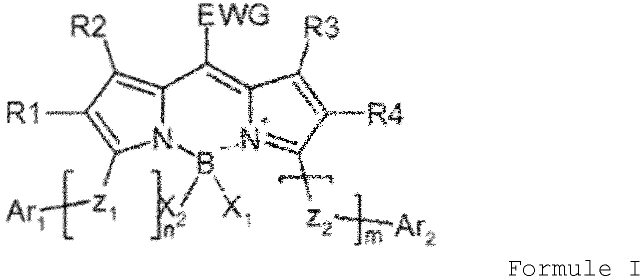 dans laquelle
a) n, m représentent chacun indépendamment l'un de l'autre 0, 1 ou 2;
b) X1, X2 sont chacun choisis indépendamment l'un de l'autre parmi un halogène, CN, un alkyle, un alkyle fluoré ou partiellement fluoré, un alcényle, un alcynyle, un alcoxy, un aryle ou un hétéroaryle;
c) EWG représente CF₃;
d) z1 et z2 sont choisis parmi les groupes (II) à (IV): 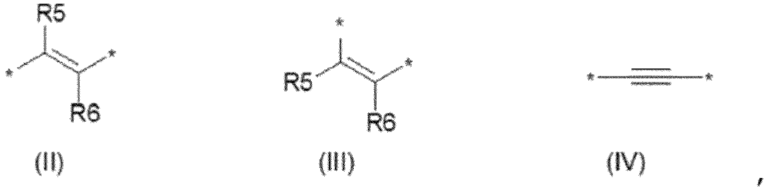 dans lesquels chaque « * » désigne un point de liaison potentielle du substituant z1, z2 au squelette cyclique dipyrrine et aux substituants aryle Ar1, Ar2,
e) R1 à R4 sont chacun indépendamment les uns des autres choisis parmi H ou un alkyle;
f) R5 et R6 sont chacun indépendamment choisis parmi H, un halogène, CN, une chaîne alkyle substituée ou non substituée, ramifiée ou non ramifiée, linéaire ou cyclique ;
g) Ar1, dans le cas dans lequel n = 0 et/ou Ar2 dans le cas dans lequel m = 0 correspondent à la formule (V), et « * » désigne le point de liaison du substituant Ar1, Ar2 au squelette cyclique dipyrrine, 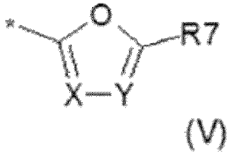 X étant choisi parmi N ou C-R8, Y étant choisi parmi N ou C-R9, R7 à R9 étant choisis indépendamment les uns des autres dans un groupe consistant en H, un halogène, un alkyle ramifié ou linéaire, cyclique ou à chaîne ouverte, ou aryle, les atomes H et/ou les atomes C de l'alkyle ou de l'aryle pouvant être substitués, ou dans un groupe consistant en un alcényle, un O-alkyle, un S-alkyle, un O-alcényle, un S-alcényle, un alcynyle, un aryle ou un hétéroaryle, les atomes H pouvant être substitués dans tous ces groupes, ou parmi CN ou NR'R", R' et R" étant chacun indépendamment de l'autre choisis parmi H, un alkyle ramifié ou linéaire, cyclique ou à chaîne ouverte, les atomes H et/ou C de l'alkyle pouvant être substitués, ou R7 et R9 pouvant ensemble former un cycle homo- ou hétérocyclique, saturé ou insaturé, substitué ou non substitué, et
Ar1, dans le cas dans lequel n > 0 et/ou Ar2, dans le cas m > 0, étant un cycle à 5 chaînons, substitué ou non substitué, hétérocyclique, de préférence par des hétéroatomes choisis parmi S ou O.

2. Composé chimique selon la revendication 1, **caractérisé en ce que** les atomes H de l'alkyle ou de l'aryle ou de l'alcényle ou de l'alcynyle de R7 à R9 sont en totalité ou en partie remplacés par un halogène, de préférence F, et/ou les atomes C de l'alkyle ou de l'aryle peuvent être remplacés par un hétéroatome, de préférence O ou S.

3. Composé chimique selon la revendication 1 ou 2, **caractérisé en ce que** R1 à R4 représentent H ou un méthyle.

4. Composé chimique selon l'une des revendications précédentes, **caractérisé en ce que** R5 et R6 sont choisis indépendamment l'un de l'autre parmi H ou un alkyle, de préférence R5 et R6 représentent H.

5. Composé chimique selon l'une des revendications précédentes, **caractérisé en ce que** X1 et/ou X2 représentent un halogène, de préférence F.

6. Composé chimique selon l'une des revendications précédentes, **caractérisé en ce que** le composé présente une symétrie spéculaire par rapport à l'axe passant par EWG et B.

7. Composé chimique selon l'une des revendications précédentes, **caractérisé en ce que**, pour ce qui concerne le composé chimique de formule générale I, il s'agit des composés suivants:

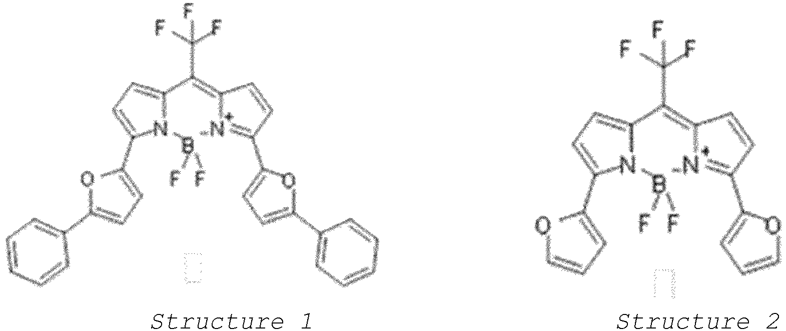

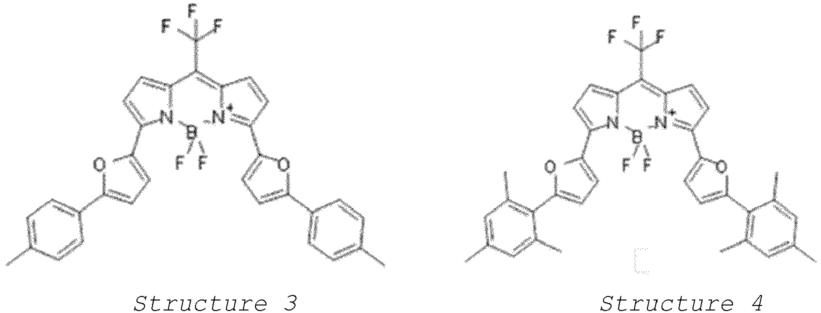

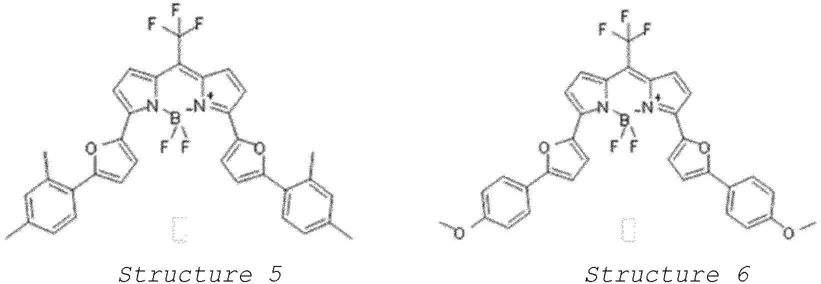

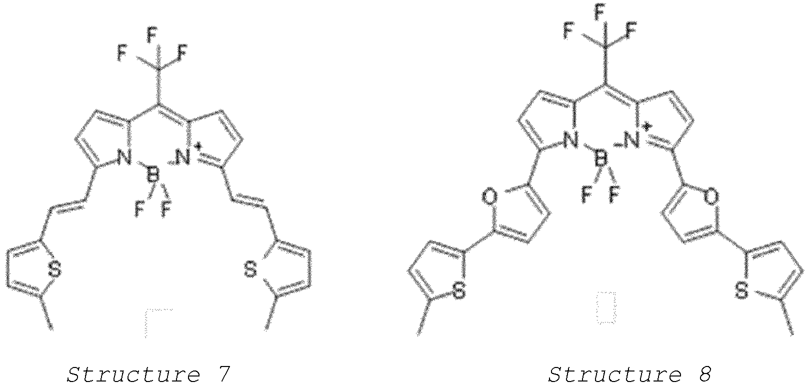

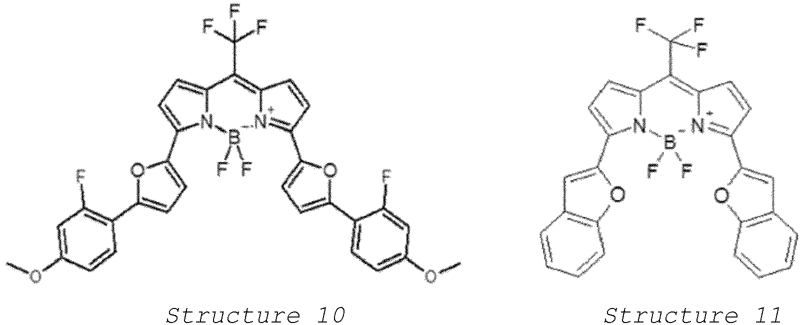

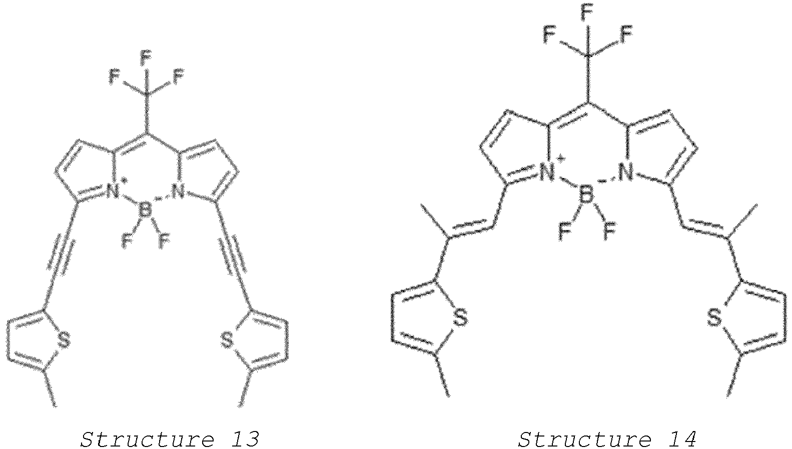

8. Fabrication du composé chimique selon la formule générale I selon l'une des revendications précédentes,
- par couplage des constituants (i0) et (i1) ou
- par couplage des constituants (i0') et (i1), suivi d'une complexation 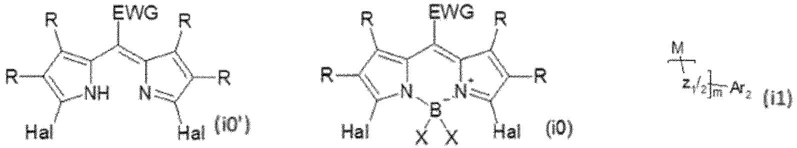 dans lesquelles
a) (i0) est synthétisé par les étapes de synthèse, dans un ordre quelconque, condensation, halogénation, oxydation et complexation;
b) (i0') est synthétisé par les étapes de synthèse, dans un ordre quelconque, condensation, halogénation et oxydation;
c) Hal représente un atome d'halogène ou un autre groupe fonctionnel pouvant être utilisé dans des réactions de couplage croisé ou -H, de préférence Hal représente un atome d'halogène; et
d) M représente un groupe fonctionnel contenant un métal ou un métalloïde, qui peut être utilisé dans des réactions de couplage croisé, ou -H,
M étant de préférence choisi parmi -SnR*3, -B(OR*)2, -Zn-Hal*, -Mg-Hal*,
R* représentant un alkyle, et les deux (OR*) pouvant former un cycle avec B, et Hal* représentant un halogène, choisi dans le groupe Cl, Br ou I.

9. Utilisation du composé chimique selon l'une des revendications précédentes 1 à 7 ou utilisation du composé fabriqué selon la revendication précédente dans des composants optoélectroniques, de préférence dans des composants optoélectroniques organiques, d'une manière particulièrement préférée dans des cellules solaires organiques, des OLED ou des photodétecteurs.

10. Utilisation selon la revendication 9 dans au moins une couche photoactive, c'est-à-dire dans une couche absorbant la lumière, d'un composant optoélectronique organique en tant qu'au moins un matériau absorbant de cette couche photoactive.

11. Composant optoélectronique organique comprenant deux électrodes, l'une étant réalisée comme électrode substrat et une autre comme contre-électrode, et entre les deux électrodes un empilement de couches comprenant au moins une cellule, qui englobe au moins une couche organique et au moins une couche de transport, **caractérisé en ce que** la couche organique et/ou la couche de transport comprennent un matériau selon l'une des revendications 1 à 7.
